# EUROPEAN PATENT SPECIFICATION

(11) **EP 2 133 448 B1**
(45) Date of publication and mention of the grant of the patent: **30.10.2019**
(21) Application number: 08721206.4
(22) Date of filing: 03.03.2008
(51) Int. Cl.: C25D 5/48, C25D 17/00, C25D 21/12, H05K 1/05

(54) **PRODUCTION METHOD AND DEVICE FOR SURFACE ROUGHENING OF A COPPER PLATE**
VERFAHREN UND VORRICHTUNG ZUR HERSTELLUNG EINER OBERFLÄCHENAUFGERAUHTEN KUPFERPLATTE
PROCÉDÉ DE FABRICATION ET DISPOSITIF POUR RUGOSIFIER LA SURFACE D'UNE PLAQUE EN CUIVRE

(30) Priority: 02.03.2007 JP 2007052568
(43) Date of publication of application: 16.12.2009
(73) Proprietor: Furukawa Electric Co., Ltd., Chiyoda-ku Tokyo 100-8322 (JP)
(72) Inventor: WATANABE, Hajime, Inukami-gun Shiga 522-0242 (JP); ISHIHAMA, Sadao, Tokyo 116-0001 (JP); YAMAMOTO, Kiyoteru, Tokyo 100-8322 (JP); IMAI, Takahiro, Inukami-gun Shiga 522-0242 (JP); OYOSHI, Toshihiro, Tokyo 100-8322 (JP)
(74) Representative: Horn Kleimann Waitzhofer Patentanwälte PartG mbB
(86) International application number: PCT/JP2008/053786
(87) International publication number: WO 2008/108341

(56) References cited:
- EP-A2- 0 709 494
- JP-A- 3 082 800
- JP-A- S5 558 389
- JP-A- 63 033 600
- JP-A- H11 298 103
- JP-A- S58 164 797
- JP-A- 2001 011 694
- JP-A- 2001 210 932
- US-A- 3 772 165
- US-A- 4 443 304
- US-A- 4 552 627

## Description

### Technical field

The present invention relates to a process for producing a copper plate to be roughened a surface thereof, that is made use for such as a metal core or the like in a metal core substrate for a circuit board, to an equipment for producing the same.

### Background art

US4552627A discloses a technique for improving the adhesive properties of a metal or metal alloy material by reducing the number of bare spots and unplated regions on each treated surface of the metal or metal alloy material. The technique comprises electrolytically forming a substantially uniform metal oxide layer on at least one surface of the material, chemically converting the oxide layer into a substantially uniform layer of fresh metal, and thereafter electrolytically forming a plurality of dendritic structures on the at least one surface. The technique of the present invention has particular utility in improving the adhesive properties of wrought copper and copper alloy foils. An apparatus for performing the technique is also described.

In US3772165A a method of treating the surfaces of metal products to provide protection against corrossive attack, comprising the steps of treating such metal products anodically in an aqueous electrolyte consisting of hexavalent chromium ions and borate ions and thereafter treating said metal products cathodically in an aqueous electrolyte consisting of hexavalent chromium ions and borate ions.

JPS6333600 (A) discloses methods to carry out pickling and to obtain a steel strip having a fine surface when oxide on the surface of a steel strip is removed by electrolytic pickling in a pickling solution by arranging anode plates and cathode plates having different lengths in the pickling solution so that they confront each other on both sides of the steel strip which is passed through the pickling solution.

EP0709494A2 discloses a method of surface-roughening treatment of a copper foil by subjecting at least one side of the copper foil to electro-plating treatment using an alternating current, wherein a sulfuric acid bath or a sulfuric acid-copper sulfate bath is used as an electrolyte.

JP03082800 discloses a method for surface roughening treatment of a material to be treated by specific voltage for electrolytic treatment when AC is supplied between the material and a counter electrode in electrolytic bath.

Here, there is designed such a metal core substrate for a circuit board to be enhanced a heat uniformity therein and a heat dissipation therefrom, by implanting a plate of metal, that is superior in thermal conductivity, into an inner portion of an insulating substrate . And then by such the implantation of the plate of metal thereinto, there becomes to be improved a thermal characteristic of such the substrate. Hence, it becomes able to flow an electric current as a larger amount therethrough even with making use of a circuit pattern as similar to therebetween. And then thereby it becomes able to design such as a circuit, a component part as peripheral therefor, or the like, to be as a smaller in size thereof.

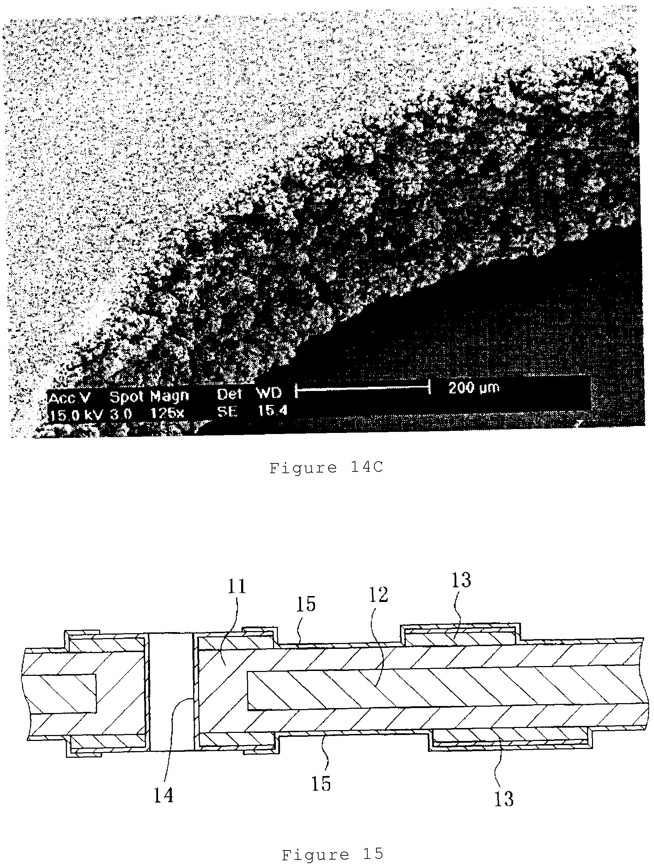

Here, FIG. 15 is a cross sectional view for showing one example of such a metal core substrate for a circuit board. According to such the figure, (11) designates an insulating substrate (a member to be hardened by pressing with heating a prepreg), (12) designates a plate of metal that is implanted into an inner portion of the insulating substrate (11), (13) designates a circuit pattern that is formed on a surface of the insulating substrate (11), (14) designates a plating for a through hole, and (15) designates a solder resist therefore.

Moreover, for a plate of metal to be a core of a metal core substrate for a circuit board, there is made use of such as a plate of copper, a plate of copper alloy, a plate of aluminum, a plate of aluminum alloy, or the like. And then it is desirable to make use of the copper plate therefor, from a point of view of thermal conductivity. Further, for such the metal core substrate for the circuit board to function the heat uniformity and the heat dissipation as sufficiently thereby respectively, even in the case where there is designed the core therefor to be made use of such the copper plate, it is designed to be selected a thickness thereof as approximately between 100 µm and 500 µm.

Still further, there is designed to be performed a soldering onto such the metal core substrate for the circuit board by making use of such as a reflow furnace or the like at a process of mounting a component thereon. And then it is required for an interface of between the core metal plate (12) and the insulating substrate (11) as not to happen any peeling off therebetween due to the heating at the period thereof. Still further, regarding a heat to be occurred at a period of making use of the circuit, there is required a sufficient adhesive property (an adherence) and also a heat resisting property for such the core metal plate and for the insulating substrate as not to be peeled off therebetween.

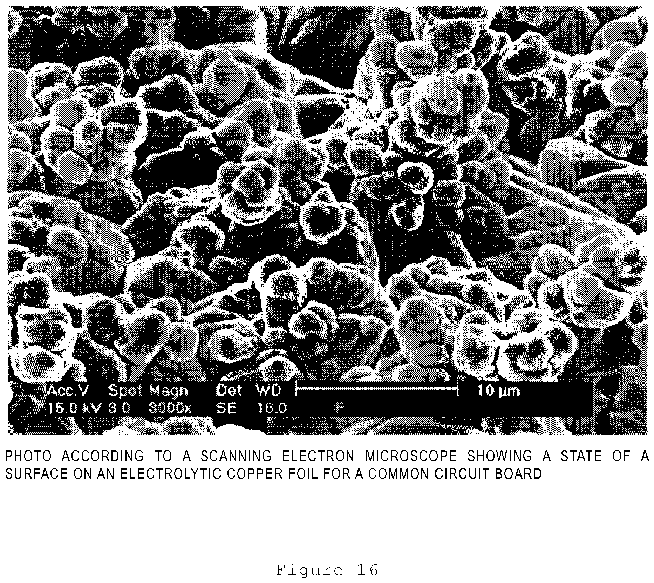

Still further, a foil of copper as an electric conducting medium in a circuit for a circuit board in general is an electrolytic copper foil, that there is designed one surface thereof to be as a roughened surface and the opposite surface therefrom to be as a brightened surface by making use of an electroplating. Still further, there becomes to be produced such the electrolytic copper foil in usual, by generating the roughened surface thereof by making use of the electroplating, and then by further performing such as a plating of copper or the like thereon to be grown a protrusion as a fine bump shape thereon. Still further, there is shown in FIG. 16 a photo according to a scanning electron microscope regarding a roughened surface of such the electrolytic copper foil for a circuit board. Still further, there is designed such the foil of copper with having a thickness as between 35 µm and 70 µm that it is able to produce the same by making use of the electroplating. On the contrary thereto, it is not able to make use of a foil of copper with having the thickness as thicker than the above mentioned range of therebetween, due to becoming a period of time for plating to be so excessively longer that it excessively increases the cost for producing such the foil of copper. Still further, it is required for such the core in the metal core substrate for the circuit board to be as the roughened surfaces for the both surfaces thereof. And then for making use of the electrolytic copper foil as such the core metal plate therein, there becomes to be required to perform a treatment of roughening for the brightened surface thereof as well, by performing an extra process to be added therefor. Hence, it becomes unable to be prevented from further increasing the cost for producing such the foil of copper.

Still further, on such the core metal plate in the metal core substrate for the circuit board, there is often designed to be opened holes as a plurality thereof, for forming individual through holes by which there is designed each part of individual circuit patterns on both surfaces thereof to be electrically conducted to therebetween. Still further, if there is designed to be performed a process of a drilling for a plate of copper, on which there is not any holes at all, after performing a treatment of roughening for the both surfaces thereof, there is a probability as higher to be damaged such the roughened surfaces thereof at a period of processing the drilling therefor. Still further, there may be a case where it becomes required to be performed an extra process for cleaning the plate again, because there may become to be adhered an oil for processing thereon at the period of processing the drilling therefor. And then according to taking into consideration thereof, it is desirable to perform such the treatment of roughening for the both surfaces thereof, after forming the holes for the through holes onto the plate of copper for the core therein.

Thus, according to the reasons as mentioned above, it is quite hard to make use of such the electrolytic copper foil for the core metal plate in the metal core substrate for the circuit board.

On the contrary thereto, if it is able to make use of a rolled plate of copper, that it is able to produce as relatively at a lower price by making use of a rolling mill roll, for a plate of copper that has a thickness of not less than approximately 100 µm which is applied as preferred to a core in a metal core substrate for a circuit board, it becomes able to be expected a cost reduction therefor as extremely lower. However, because such the rolled plate of copper has surfaces to be as smooth for both thereof, and then in a case of implanting such the plate of copper into an inner portion of an insulating substrate, it becomes to be required to perform a treatment of roughening for such the both surfaces thereof, for enhancing the adhesive property to between a substance for the insulating substrate (a glass epoxy board).

Moreover, as a process for roughening a surface of a copper plate, there is provided a process for roughening the surface of the copper plate by performing such as an etching therefor, a chemical treatment therefor, or the like. And then as a typical example thereof, it is able to be provided the CZ treatment that is proposed by MEC COMPANY LTD. Further, such the CZ treatment is a process to form a particle of copper to be etched and a coating film layer that is comprised of chemical compound of organic nitrogen on a surface of a copper plate, by making use of a reaction of oxidation or of reduction according to a chemical compound of bivalent copper. Still further, it is regarded that it is able to be obtained a strength against peeling as pursuant to the JIS-C6471 to be as between 0.4 kN/m and 0.8 kN/m or stronger than the range thereof. And then in a case of having the strength against peeling approximately as such the degree of magnitude therefor, it becomes able to satisfy a minimum requirement presently as a process of roughening to be made use for adhering to between an insulating substrate.

Still further, there is heretofore known a process for forming a protrusion as a fine bump shape on a surface of a copper plate by performing a process of plating copper with a density of an electric current as higher, such as a foil of copper for a printed circuit board or the like (refer to a patent document 1 for example). Furthermore, such the protrusion as the fine bump shape thereon is extremely effective for enhancing the adhesive property to between the substance for the insulating substrate because the same has an effect of anchoring therebetween, comparing to making use of the process of the etching therefor, the process of the chemical treatment therefor, or the like.
[Patent Document 1] Japanese Patent Application Publication No. 2005-008973

### Disclosure of the invention

### Problems to be solved by the invention

However, in a case of roughening a surface of a rolled plate of copper, it is able to obtain only a surface thereof to be roughened as excessively shallower comparing to that of an electrolytic copper foil according to making use of the process of the etching therefor, the process of the chemical treatment therefor, or the like. And then thereby there becomes to be decreased the strength against peeling comparing to that of the electrolytic copper foil. Moreover, it is not able to obtain a reliability thereby regarding the heat resisting property thereof as similar to that of the electrolytic copper foil either. Further, according to such the process of the etching therefor, there becomes to be generated a foul solution as a large quantity thereof with corresponding to a number of the processes thereof. And then thereby it is not desirable to be performed such the process from a point of view of such as a cost for producing thereof, an environmental issue thereby, or the like.

Further, according to the process as disclosed in the patent document 1, in which there becomes to be roughened the surface of the foil of copper by performing the process of plating copper thereon, there becomes to be progressed excessively a deterioration of a solution for plating copper, because there is designed to be performed such the process of plating copper thereon with the density of the electric current as higher. And then thereby there becomes to be consumed such the solution for plating copper as a larger amount thereof. As a result, there becomes to be occurred a difficult point that it becomes to be increased thereby the cost for producing thereof as higher.

Still further, there is designed such the electrolytic copper foil to be produced by performing the plating thereon under a state that one surface thereof is contacted to an electrode of drum which is rotating. Hence, there becomes to be roughened only one surface of such the foil of copper. And then thereby it becomes to be further required for a brightened surface thereof to be roughened by making use of another process for plating copper thereon. Thus, according to the process for roughening the surface of the copper foil by making use of such the process of plating copper thereon, it is hard to apply to the roughening for the both surfaces of the plate of copper.

And then therefore, an object of the present invention is to provide a process for producing a copper plate to be roughened a surface thereof, and to provide an equipment for producing the same, by which a deterioration of an electroplating solution for plating copper thereon becomes hard to progress therein, and by which it becomes able to roughen the both surfaces of the copper plate at the same time therefor, that is independent of an existence or a nonexistence of any of holes thereon for individual through holes.

### Means for solving the problem

The problem is solved by the invention according to the appended independent claims.

A process for producing a copper plate to be roughened a surface thereof, for roughening the surface of the copper plate by forming a protrusion as a fine bump shape on the surface of the copper plate, according to the present invention is characterized in that it becomes able to form the protrusion as the fine bump shape thereon by comprising the following steps of: arranging electrodes as a similar pole for therebetween to be opposed to each other in an electroplating solution for plating copper; arranging the copper plate at between the electrodes; performing an anodic treatment for generating a fine particle of copper on both surfaces of the copper plate, by performing an electrolytic process with the copper plate as a positive electrode therefor and the electrodes as negative electrodes therefor; performing a cathodic treatment after performing the anodic treatment, by performing an electroplating of copper with the copper plate as a negative electrode therefor and the
electrodes as positive electrodes therefor, for the fine particle of copper to be fixed onto the surfaces of the copper plate; and performing the anodic treatment and then the cathodic treatment, that are defined to be as one cycle, as not less than the one cycle therefor.

Moreover, regarding the process for producing the copper plate according to the present invention, there may be designed to be performed a process for a plating of copper, for adjusting a thickness of the plate, with the copper plate as the negative electrode therefor and the electrodes as the positive electrodes therefor in an electroplating solution for plating copper in which there becomes to be performed the anodic treatment therefor and then the cathodic treatment therefor, before performing the anodic treatment for the first time. Further, in the case of performing such the process thereof, there becomes to be performed a process of roughening for the thickness of the plate after performing the process for the plating of copper for the adjustment of the thickness of the plate.

Still further, regarding the process for producing the copper plate according to the present invention, it may be able to produce a copper plate to be roughened a surface thereof as well, by comprising the following steps of: arranging one pair of electrodes as a similar pole for therebetween to be opposed to each other in an electroplating solution for plating copper; arranging a copper plate at between the one pair of the electrodes as the similar pole for therebetween; and performing the anodic treatment therefor and then the cathodic treatment therefor as not less than the one cycle thereof, without moving the copper plate at all for the electrodes as the similar pole for therebetween.

Still further, regarding the process for producing the copper plate according to the present invention, it may be able to produce a copper plate to be roughened a surface thereof as well, by comprising the following steps of: arranging one pair of positive electrodes to be opposed to each other in an electroplating solution for plating copper and one pair of negative electrodes to be opposed to each other in the similar solution to be in a tandem manner; arranging a copper plate at between the negative electrodes; performing an anodic treatment therefor with the copper plate as a positive electrode therefor; moving the copper plate relatively for between the positive electrodes; performing a cathodic treatment therefor with the copper plate as a negative electrode therefor; and performing the anodic treatment therefor and then the cathodic treatment therefor, that are defined to be as one cycle, as not less than the one cycle thereof.

Still further, regarding the process for producing the copper plate according to the present invention, it may be able to produce a copper plate to be roughened a surface thereof as well, by comprising the following steps of: arranging one pair or pairs as a plurality of positive electrodes (a group) to be opposed to each other in an electroplating solution for plating copper and one pair or pairs as a plurality of negative electrodes (a group) to be opposed to each other in the similar solution to be alternately in a tandem manner with having a number thereof as corresponding to a number of the cycles of the treatments therefor; moving a copper plate from between the electrodes at a side for one end thereof to between the electrodes at a side for the other end thereof as relatively one after the other; and performing the anodic treatment therefor and then the cathodic treatment therefor as one after the other.

Still further, regarding the process for producing the copper plate according to the present invention, it may be able to obtain the copper plates as the two sheets that become to be individually roughened one side of the surfaces for each thereof as well, by comprising the following steps of: performing an anodic treatment for a copper plate to be combined, that copper plates as two sheets are overlapped to be formed as a form of one sheet, by performing any one of the processes as defined above; performing a cathodic treatment therefor, by performing the processes in a similar manner; and separating the combined copper plate into each one of the copper plates.

Still further, according to the process for producing the copper plate regarding the present invention, it is desirable for the anodic treatment therefor to be performed with an electric current density of between 1 A/dm² and 8 A/dm² for between three minutes and ten minutes, and it is desirable for the cathodic treatment therefor to be performed with an electric current density of between 1 A/dm² and 8 A/dm² for between three minutes and ten minutes as well.

Still further, according to the process for producing the copper plate regarding the present invention, it is desirable for the electroplating solution for plating copper to be maintained a temperature thereof as between 18 °C and 32 °C. Still further, it is further preferable for the electroplating solution for plating copper to be maintained the temperature thereof as between 24 °C and 30 °C.

Still further, regarding the process for producing the copper plate according to the present invention, it is desirable to form beforehand a predetermined hole at a predetermined position on a copper plate, before performing any one of the anodic treatments therefor or of the cathodic treatments therefor.

Still further, regarding an equipment for producing a copper plate to be roughened a surface thereof according to the present invention, it is desirable to be designed the same as comprising the following configuration of: an electrolytic bath for housing an electroplating solution for plating copper; one pair of positive electrodes to be opposed to each other in the electrolytic bath and to be arranged in a tandem manner therein; one pair of negative electrodes to be opposed to each other in the electrolytic bath and to be arranged in a tandem manner therein; a bus bar for a negative electrode, that is designed to be arranged horizontally at an upper side for between the one pair of the positive electrodes, and that is for hanging the copper plate; a bus bar for a positive electrode, that is designed to be arranged horizontally at an upper side for between the one pair of the negative electrodes, and that is for hanging the copper plate; and an insulating bar for connecting to between the bus bar for the negative electrode and the bus bar for the positive electrode.

Still further, regarding an equipment for producing a copper plate to be roughened a surface thereof according to the present invention, it is further preferable to be designed the same as comprising the following configuration of: an electrolytic bath for housing an electroplating solution for plating copper; one pair or pairs as a plurality of positive electrodes (a group) to be opposed to each other in the electrolytic bath and one pair or pairs as a plurality of negative electrodes (a group) to be opposed to each other in the similar bath and to be arranged alternately in a tandem manner with having a number thereof as corresponding to a number of the cycles of the treatments therefor; a bus bar for a negative electrode, that is designed to be arranged horizontally at an upper side for between each of the individual pairs of the positive electrodes, and that is for hanging the copper plate; a bus bar for a positive electrode, that is designed to be arranged horizontally at an upper side for between each of the individual pairs of the negative electrodes, and that is for hanging the copper plate; and an insulating bar for connecting to between the bus bar for the negative electrode and the bus bar for the positive electrode that are adjacent to each other.

Still further, a copper plate to be roughened a surface thereof according to the present invention is characterized in that a predetermined hole is designed to be formed at a predetermined position on the copper plate to be roughened a surface thereof, a grain size of a protrusion as a fine bump shape to be formed on the surface of the copper plate is designed to be as not larger than 10 µm, and a surface roughness thereof as an Rz is designed to be as between 3 µm and 20 µm. Furthermore, in such the case thereof, it is desirable for an inner face of the hole thereon to be roughened, and then it is desirable as well for a height of a protrusion as a fine bump shape to be formed at the inner face of the hole thereon is designed to be as not higher than 20 µm.

### Effects of the invention

According to the present invention, it becomes able to form the protrusion as the fine bump shape on both of the surfaces of the copper plate and then thereby to roughen both of such the surfaces of the copper plate, by comprising the following steps of: performing the anodic treatment for generating such the fine particle of copper on both of the surfaces of the copper plate, by performing the electrolytic process with the copper plate as the positive electrode therefor and the above mentioned electrodes as the negative electrodes therefor; performing the cathodic treatment therefor, by performing the plating of copper with the above mentioned copper plate as the negative electrode therefor and the above mentioned electrodes as the positive electrodes therefor, for the above mentioned fine particle of copper to be fixed onto the surfaces of the copper plate. Moreover, there becomes to be supplied ions of copper from the plate of copper therein at a period of the process for the anodic treatment, and then there becomes to be consumed such the ions of copper in the solution at a period of the process for the cathodic treatment, because there are designed to be performed such the above mentioned anodic treatment therefor and such the cathodic treatment therefor in the electroplating solution for plating copper as similar to therebetween. And then thereby it becomes able to reduce extremely a variation in concentration of such the ions of copper in the processing solvent therefor, by designing each of values of the electric currents to be close to each other at individual periods of the processing therefor respectively. Hence, there becomes to be hard to progress the deterioration of the electroplating solution for plating copper therein, and then thereby it becomes possible to make use of such the electroplating solution for plating copper over a long period of time therefor. As a result, it becomes able to reduce a quantity of the electroplating solution for plating copper to be consumed therefor, and then thereby it becomes able to reduce the cost for producing thereof. Further, it is desirable for each of the values of the electric currents at the period of the anodic treatment therefor and at the period of the cathodic treatment therefor to be designed as similar to therebetween. However, even in a case where there is existing a difference for therebetween, it becomes able to suppress extremely the consumption of the copper ions therein comparing to any ordinary plating of copper thereon. Still further, it becomes able to roughen at the same time for such as both of the surfaces of such the copper plate, the inner face of the hole for the through hole thereon, or the like, and then thereby it becomes able to obtain easier such the copper plate to be roughened the surface thereof, that is applicable as preferred to such as the metal core or the like in the metal core substrate for the circuit board.

Still further, it becomes able to obtain other advantages that it becomes easier for the protrusion as the fine bump shape to be formed thereon, and it becomes able to perform an adjustment of a thickness of the plate of copper as well, in a case where there is designed to be performed the process of the plating of copper, with the plate of copper as the negative electrode therefor and the electrodes as the positive electrodes therefor, before performing the anodic treatment for the first time.

Still further, it becomes possible to obtain the plates of copper as the two sheets that become to be individually roughened each one side of the surfaces for each thereof as well, by comprising the following steps of: performing the anodic treatment for the plate of copper to be combined, that the plates of copper as the two sheets are overlapped to be formed as the form of one sheet; performing the cathodic treatment therefor; and then thereafter separating such the combined plate of copper into each one of the plates of copper. Still further, according to such the plates of copper to be obtained in such a manner, that become to be individually roughened each one side of the surfaces for each thereof, it becomes able to keep the other side of the surfaces for each thereof to be as smooth, because there becomes seldom happened to be roughened at around such the other side of the surfaces comparing to the individual surfaces to be roughened thereby.

Furthermore, it becomes able to apply the equipment for producing such the plate according to the present invention to another type of process for plating, such as a horizontal line therefor, a vertical line therefor, a pusher line therefor, or the like, as well as that according to the present invention if it satisfy a basic principle of the method for plating according to the present invention.

### Best mode for carrying out the invention

### The first embodiment

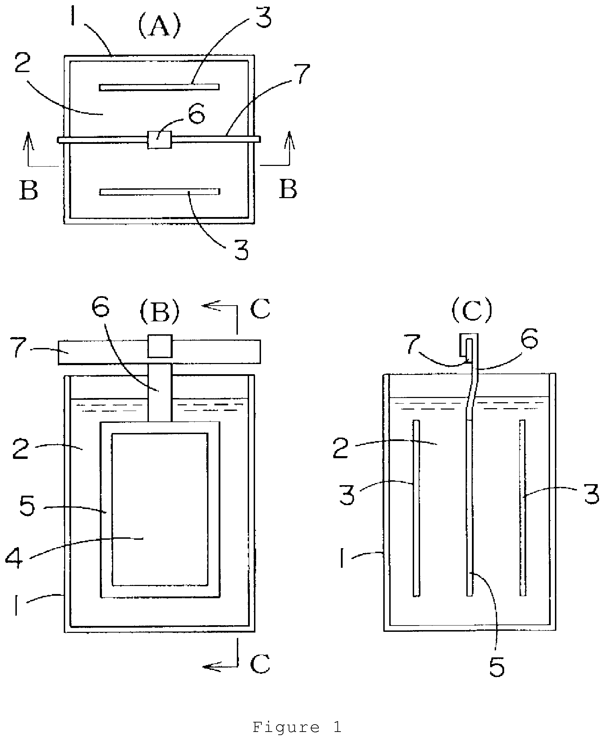

Here, FIG. 1 shows one embodiment according to the present invention. According to such the figure, (1) designates an electrolytic bath, (2) designates an electroplating solution for plating copper that is housed in the electrolytic bath (1), (3) and the other (3) designates electrodes as one pair that are arranged to be opposed to each other in the electroplating solution for plating copper (2), (4) designates a plate of copper that is arranged at between the electrodes as (3) and the other (3) to be roughened a surface thereof, (5) designates a frame body for holding the plate of copper (4), (6) designates a hanger metal fitting therefor, and (7) designates a bus bar for maintaining the plate of copper (4) to be as a positive electrode or as a negative electrode via the hanger metal fitting (6) and the frame body (5). Moreover, there is omitted any electrical wiring to be shown in such the figure, that is designed to maintain the electrodes as (3) and the other (3) to be an electric pole as opposite to that of the plate of copper (4).

Further, there is designed to be made use of a plate of copper or a bar of copper for such the electrodes as (3) and the other (3) therein. Still further, it is possible to make use of an insoluble electrode to be on the market as well (such as an insoluble electrode of oxide based with making use of titanium to be as a base material therefor, an insoluble electrode of platinum based, or the like). Still further, there is designed such the electrode normally to be made use of a member that has an area as opposed and then similar to one surface of the copper plate to be roughened thereby. However, it is all right to perform an increase or a decrease in such the area thereof, or to perform a division into a plurality of sheets therefor, as pursuant to the circumstances corresponding thereto. Still further, the electroplating solution for plating copper (2) is an electroplating solution for plating copper to be on the market . Still further, there is designed a composition of the solution for plating copper (2) to be as for example: sulfate of copper of between 40 g/l and 250 g/l; sulfuric acid of between 30 g/l and 210 g/l; hydrochloric acid of between 10 ppm and 80 ppm; and an additive agent, such as a brightening agent or the like, with a quantity to be specified by a maker therefor (as approximately between 2 ml/l and 10 ml/l). Furthermore, there is designed the solution for plating copper (2) to be agitated, by making use of such as a unit for agitating pneumatically (a bubbling) that is arranged at a bottom part of the electrolytic bath (1), a jet nozzle to be arranged at between the electrode in the bath (1) and the plate of copper to be roughened the surface thereof, or the like (that are omitted to be shown in the figures).

And then in the equipment to be configured in the above mentioned manner, there is designed to be performed first of all an anodic treatment for generating a fine particle of copper on both of the surfaces of the copper plate (4), with a quantity to be required for forming a protrusion as a fine bump shape thereon, by performing an electrolytic process with the plate of copper (4) as a positive electrode therefor and the electrodes (3) and the other (3) as negative electrodes therefor. Next, there becomes to be reversed such the electric poles to therebetween, and then thereafter there becomes to be performed a cathodic treatment, by performing an electroplating with the plate of copper (4) as a negative electrode therefor and the electrodes (3) and the other (3) as positive electrodes therefor, for such the above mentioned fine particle of copper to be fixed onto the surfaces of the copper plate (4). And then by performing such the anodic treatment therefor and then the cathodic treatment therefor, it becomes able to form the protrusion as the fine bump shape onto the surfaces of the copper plate, that is superior in adhesive property to between a substance for an insulating substrate, as similar to that according to the protrusion as the fine bump shape on the surfaces of the conventional electrolytic copper foil. Moreover, there is designed to be moved out such the copper plate to be roughened the surface thereof, that is finished the cathodic treatment therefor, to an outer side of the electrolytic bath (1), and then there is designed to be performed a process of washing in clear water therefor. Further, there is designed to be performed an after treatment as required therefor, such as a process of an acid cleaning therefor, another process of washing in clear water therefor, a process for a prevention of rust, or the like. Still further, there is designed such the after treatment therefor as similar to the after treatment to be performed for the normal processes of the electroplating of copper.

Still further, such the fine particle of copper to be generated according to the process of the anodic treatment therefor is so called an anode slime as a nuisance in general at the period of the electroplating of copper, that is considered to be generated due to a retention of such as copper, copper oxide, ions of copper, or the like, with a concentration to be as higher on the surface of the copper plate, because of a difference between a rate of the copper ions to be precipitated from the plate of copper and a diffusion rate of the ions into the solution for plating thereof according to such the anodic treatment therefor. However, according to the present invention, there is designed to be positively made use of such the anode slime for forming the protrusion as the fine bump shape thereon. Still further, regarding the fine particle of copper to be generated therein, it cannot help but be removed from the surface of the copper plate in a case where there is the quantity thereof as excessively larger, and then thereby it is not able to form the protrusion as the fine bump shape thereon. Still further, it is not able to form the protrusion as the fine bump shape thereon in a case where there is the quantity thereof as excessively smaller. Still further, regarding a condition of the anodic treatment for the fine particle of copper to be generated therein with the quantity thereof to be required for forming the protrusion as the fine bump shape on the surface of the copper plate, it is different from every case thereof due to such as a density of an electric current therethrough, an amount of time for processing thereof, a temperature of the solution therefor, or the like, and then it is evaluated experimentally. Still further, regarding the condition of such the anodic treatment as preferred thereto according to the experiment therefor, there are obtained that the density of the electric current therethrough as between 1 A/dm² and 8 A/dm², the temperature of the solution therefor as between 18 °C and 32 °C, and that the amount of time for processing thereof as between three minutes and ten minutes. Still further, regarding the cathodic treatment for such the fine particle of copper, that becomes to be generated thereby, to be fixed onto the surfaces of the copper plate, it is evaluated experimentally as similar thereto. Still further, regarding the condition of such the cathodic treatment as preferred thereto according to the experiment therefor, there are obtained that the density of the electric current therethrough as between 1 A/dm² and 8 A/dm², the temperature of the solution therefor as between 18 °C and 32 °C, and that the amount of time for processing thereof as between three minutes and ten minutes. Thus, such the individual conditions thereof are approximately similar to the individual conditions of the ordinary electroplating of copper respectively.

Here, an important point according to the present invention is that there becomes found out that it becomes able to form such the protrusion as the fine bump shape thereon, not by performing any processes of the electroplating of copper with the density of the electric current therethrough as higher, such as the process for roughening the surface of the electrolytic copper foil, but by performing the process for generating the fine particle of copper and then by performing the process for fixing the same thereon with making use of the individually conditions of the ordinary electroplating of copper. Moreover, according to such the processes therefor, there are designed to be performed the individual processes of such the anodic treatment therefor and then such the cathodic treatment therefor in the electroplating solution for plating copper as similar to therebetween. And then thereby it becomes able to reduce a consumption of the ions of copper therein. Hence, there becomes to be less progressed the deterioration of the electroplating solution for plating copper therein, and then thereby it becomes able to make use of such the solution for plating thereof over a long period of time therefor. As a result, it becomes able to reduce thereby the quantity of such the solution for plating thereof to be consumed therefor.

Further, it is possible to roughen the surface of the copper plate by performing the individual processes of such the anodic treatment therefor and then such the cathodic treatment therefor as only one cycle thereof. However, in a case where there is required to obtain the heat resisting property thereof as further higher, it is desirable to perform such the processes as not less than two cycles thereof. Still further, it may be available to perform the process of the electroplating of copper by making use of the equipment as similar thereto before performing the process of the anodic treatment therefor at the first time. Still further, such the process for the electroplating of copper is effective for such as forming such the protrusion as the fine bump shape thereon as further easier, for performing the adjustment of the thickness of such the copper plate, or the like.

Still further, it becomes possible to obtain the copper plates as the two sheets that become to be individually roughened each one side of the surfaces for each thereof as well, by comprising the following steps of: performing the anodic treatment for the copper plate to be combined, that the copper plates as the two sheets are overlapped to be formed as the form of one sheet; performing the cathodic treatment therefor; and then thereafter separating such the combined copper plate into each one of the copper plates (it is similar for the embodiments as described below). Furthermore, according to such the plates of copper to be obtained in such a manner, that become to be individually roughened each one side of the surfaces for each thereof, it becomes able to keep the other side of the surfaces for each thereof to be as smooth, because there becomes seldom happened to be roughened at around such the other side of the surfaces comparing to the individual surfaces to be roughened thereby.

### The second embodiment

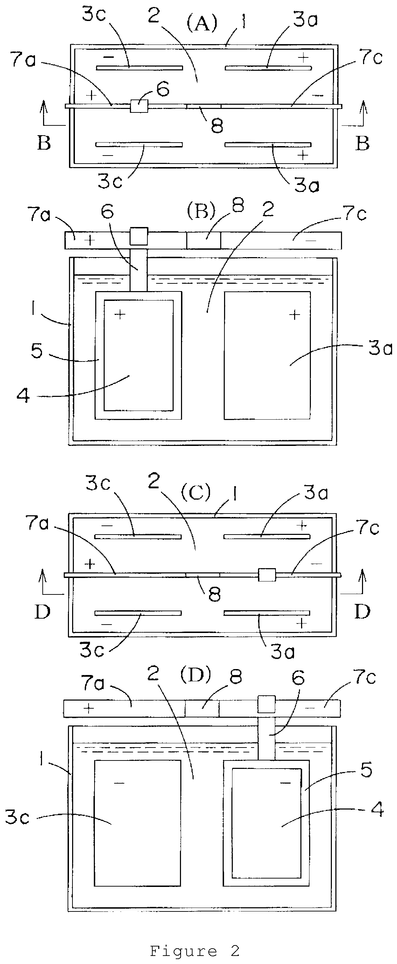

Here, FIG. 2 shows another embodiment according to the present invention. And then in FIG. 2, there is made use of a similar symbol for a part therein as similar to that according to FIG. 1. Here, a point according to this embodiment to be different from that according to the first embodiment is that there are designed to be longer the electrolytic bath (1), to be arranged one pair of positive electrodes as (3a) and the other (3a) for becoming opposed to each other, and to be arranged one pair of negative electrodes as (3c) and the other (3c) for becoming opposed to each other, that are arranged in a tandem manner in the electroplating solution for plating copper (2) respectively. Moreover, there is designed a bus bar for a negative electrode (7c), that is designed to be arranged horizontally at an upper side for intermediately between the above mentioned one pair of the positive electrodes as (3a) and the other (3a) therein. Further, there is designed a bus bar for a positive electrode (7a), that is designed to be arranged horizontally at an upper side for intermediately between the above mentioned one pair of the negative electrodes as (3c) and the other (3c) therein. Still further, there are designed such the bus bar for the negative electrode (7c) and the bus bar for the positive electrode (7a) to be connected to therebetween in a linear form via an insulating bar (8). Still further, there is designed to be made use of a plate of copper or a bar of copper for such the negative electrodes as (3c) and the other (3c) therein. Still further, it is possible to make use of a plate of copper or a bar of copper for such the positive electrodes as (3a) and the other (3a) therein, however, it is desirable to make use of an insoluble electrode (such as an insoluble electrode of oxide based with making use of titanium to be as a base material therefor, an insoluble electrode of platinum based, or the like). Still further, there are designed for both of such the negative electrodes and such the positive electrodes normally to be individually made use of a member that has an area as opposed and then similar to one surface of the copper plate to be roughened thereby. However, it is all right to perform an increase or a decrease in such the area thereof, or to perform a division into a plurality of sheets therefor, as pursuant to the circumstances corresponding thereto.

For producing a copper plate to be roughened a surface thereof by making use of such the equipment therefor, there is designed to be arranged the plate of copper (4) at between the negative electrodes therefor as (3c) and the other (3c) first of all with being hung up by making use of the bus bar for the positive electrode (7a) as shown in FIG. 2 (A) and in (B), and then to be performed an anodic treatment therefor with such the plate of copper (4) to be as the positive electrode therein. And then thereby there is designed to be generated a fine particle of copper with a quantity to be required for forming a protrusion as a fine bump shape on both of the surfaces of the copper plate (4). And then after finishing such the anodic treatment therefor, there is designed for the hanger metal fitting (6) to be moved from the bus bar for the positive electrode (7a) over the insulating bar (8) and then to the bus bar for the negative electrode (7c), there is designed to be arranged the plate of copper (4) at between the positive electrodes as (3a) and the other (3a) thereafter, and then there is designed to be performed a cathodic treatment therefor with such the plate of copper (4) to be as the negative electrode therein under such the state thereof. And then by performing the process of such the cathodic treatment therefor (plating of copper thereon), there becomes to be fixed such the fine particle of copper onto the plate of copper, that is generated on the surfaces of the copper plate. And then thereby it becomes able to be formed the protrusion as the fine bump shape onto the surfaces of the copper plate. Moreover, there is designed to be moved out such the copper plate to be roughened the surface thereof, that is finished the cathodic treatment therefor, to an outer side of the electrolytic bath (1), and then there is designed to be performed a process of washing in clear water therefor. Further, there is designed to be performed an after treatment as required therefor, such as a process of an acid cleaning therefor, another process of washing in clear water therefor, a process for a prevention of rust, or the like.

Still further, it may be available to perform the individual processes of such the anodic treatment for the plate of copper and then such the cathodic treatment therefor as only the one cycle thereof, However, it is desirable to perform such the processes therefor as not less than two cycles thereof. Still further, in the case of performing such the processes as not less than the two cycles thereof, there is designed for the plate of copper to be moved back to between the negative electrodes as (3c) and the other (3c) after finishing the cathodic treatment therefor in the previous cycle thereof, and then thereafter there is designed to be performed an anodic treatment therefor. Still further, even in the case of performing such the processes as not less than the two cycles thereof, there is designed to be ended by performing a process of a cathodic treatment therefor in the end. Still further, it may be available to perform the process of the electroplating of copper, by arranging the plate of copper at between the negative electrodes, before performing the process of the anodic treatment therefor at the first time.

Furthermore, in a case of finishing such the individual processes of such the anodic treatment therefor and then such the cathodic treatment therefor as just the one cycle thereof, it becomes able to perform the processes of another anodic treatment therefor for the next and such the cathodic treatment therefor at the same time thereof as well, by arranging another copper plate to be roughened the surface thereof for the next at between the negative electrodes as (3c) and the other (3c) to be opened the space therebetween, at a time of performing the cathodic treatment for the plate of copper, that is finished performing the process of such the anodic treatment therefor and then to be moved to between the positive electrodes as (3a) and the other (3a) as shown in FIG. 2 (C) and in (D). And then by performing the processes in such a manner, it becomes able to design an efficiency of the production for the plates of copper to be roughened the individual surfaces thereof as approximately two times as the case according to the first embodiment.

### The third embodiment

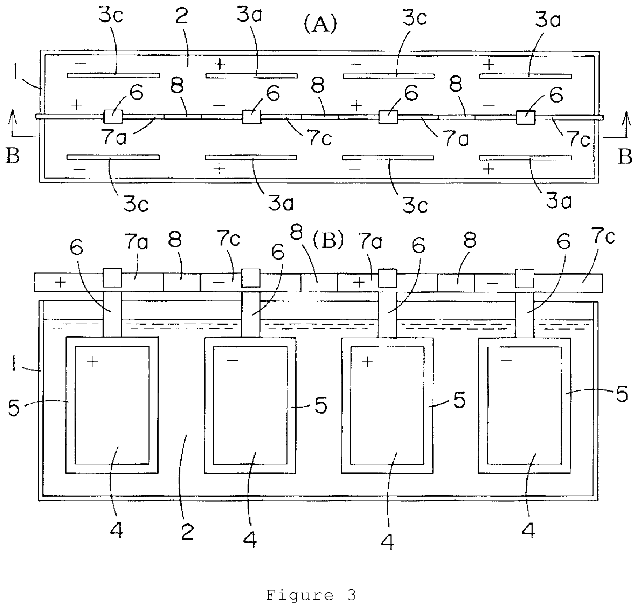

Here, FIG. 3 shows further another embodiment according to the present invention. And then in FIG. 3, there is made use of a similar symbol for a part therein as similar to that according to FIG. 2. Moreover, there is designed to be longer for a length of the electrolytic bath (1) as approximately two times as that of the equipment as shown in FIG. 2, for performing the processes of the anodic treatment for the plate of copper and then of the cathodic treatment therefor as two times thereof, and then there is designed to be arranged therein one pair of positive electrodes as (3a) and the other (3a) for becoming opposed to each other, and to be arranged therein one pair of negative electrodes as (3c) and the other (3c) for becoming opposed to each other, that are arranged alternately in a tandem manner in the electroplating solution for plating copper (2) respectively. Further, there is designed the bus bar for the negative electrode (7c), that is designed to be arranged horizontally at the upper side for intermediately between the one pair of the positive electrodes as (3a) and the other (3a) therein. Still further, there is designed the bus bar for the positive electrode (7a), that is designed to be arranged horizontally at the upper side for intermediately between the one pair of the negative electrodes as (3c) and the other (3c) therein. Furthermore, there are designed such the bus bar for the negative electrode (7c) and the bus bar for the positive electrode (7a), that are adjacent to each other, to be connected to therebetween in a linear form via the insulating bar (8).

For producing a copper plate to be roughened a surface thereof by making use of such the equipment therefor, there may be designed to be moved the plate of copper (4) from between the negative electrodes as (3c) and the other (3c) at a side of one end in the electrolytic bath (1) (at left side in such the figure) to between the positive electrodes as (3a) and the other (3a) at a side of the other end therein as one after the other thereof, and then to be performed such the anodic treatment therefor and then the cathodic treatment therefor as one after the other thereof. Moreover, there is designed to be moved out such the copper plate to be roughened the surface thereof, that is finished the cathodic treatment therefor at between the positive electrodes as (3a) and the other (3a) at the side of the other end therein, to an outer side of the electrolytic bath (1), and then there is designed to be performed a process of washing in clear water therefor. Further, there is designed to be performed an after treatment as required therefor, such as a process of an acid cleaning therefor, another process of washing in clear water therefor, a process for a prevention of rust, or the like. Still further, after moving out such the plate of copper (4) from between the positive electrodes as (3a) and the other (3a) at the side of the other end therein to the outer side of the electrolytic bath (1), there are designed for the remaining plates of copper as the three sheets to be individually moved as one pitch therefor to the side of the other end thereof, and then thereafter there is designed to be arranged another copper plate for the next to be roughened a surface thereof at between the negative electrodes as (3c) and the other (3c) at the side of the one end therein that becomes to be opened the space therebetween. And then thereafter there are designed to be performed an anodic treatment therefor and a cathodic treatment therefor for between all of the electrodes therein at the same time thereof. Thus, by designing in such a manner therefor, it becomes able to be performed the anodic treatments therefor and then the cathodic treatments therefor as the two cycles thereof as continuously.

Still further, there is designed to be made use of a plate of copper or a bar of copper for such the negative electrodes as (3c) and the other (3c) therein. Still further, it may be able to make use of a plate of copper or a bar of copper for such the positive electrodes as (3a) and the other (3a) therein, however, it is desirable to make use of an insoluble electrode (such as an insoluble electrode of oxide based with making use of titanium to be as a base material therefor, an insoluble electrode of platinum based, or the like). Still further, there are designed for both of such the negative electrodes and such the positive electrodes normally to be individually made use of a member that has an area as opposed and then similar to one surface of the copper plate to be roughened thereby respectively. However, it is all right to perform an increase or a decrease in such the area thereof, or to perform a division into a plurality of sheets therefor, as pursuant to the circumstances corresponding thereto.

Still further, in a case of performing such the processes for plates of copper as further larger number of sheets thereof, or in a case of performing such the processes for further larger quantity thereof, there are designed for a unit of a cathodic treatment therefor and for a unit of an anodic treatment therefor individually to have lengths and numbers thereof as a plurality of times as the above mentioned case, with corresponding to each of the electrodes therefor as a plurality of pairs to be opposed to each other. Still further, by performing the processes for the plates of copper at the same time thereof with a number thereof as corresponding to a multiple of such the above mentioned number thereof, and then by increasing a travelling speed for each of the copper plates respectively, with corresponding to such the multiple of the number thereof, it becomes able to enhance a tact time for processing thereof as arbitrarily therefor. Still further, in such the case thereof, there may be designed to be set a ratio of a length of a processing bath, with corresponding to such as a number of each of a cathodic treatment therefor and of an anodic treatment therefor, a time ratio of therebetween, or the like to be required therefor. Thus, by designing to be such the equipment therefor, it becomes able to produce the copper plate to be roughened the surface thereof, with the tact time therefor to be not longer than the amount of time to be required for such the cathodic treatment therefor or for such the anodic treatment therefor.

Still further, it may be available to perform the individual processes of such the anodic treatment therefor and then such the cathodic treatment therefor as not less than three cycles thereof as required therefor. Furthermore, in the case of performing such the processes as not less than the three cycles thereof, it may be available to design to be arranged therein one pair of positive electrodes as (3a) and the other (3a) for becoming opposed to each other, and to be arranged therein one pair of negative electrodes as (3c) and the other (3c) for becoming opposed to each other, that are arranged alternately in a tandem manner as not less than three sets for each of such the pairs thereof respectively.

### (Conditions of the anodic treatment)

Here, there are determined conditions of such the anodic treatment therefor according to an experiment. And then according to the experiment, for generating the fine particles of copper with the quantity thereof to be required for forming the protrusion as the fine bump shape on both of the surfaces of the copper plate, it may be available to perform the processes therefor in an ordinary electroplating solution for plating copper (the sulfate of copper as between 40 g/l and 250 g/l, the sulfuric acid as between 30 g/l and 210 g/l, the hydrochloric acid as between 10 ppm and 80 ppm, and an additive agent of such as a brightening agent or the like with a quantity to be specified by a maker therefor), with keeping the temperature of the solution for plating thereof as between 18 °C and 32 °C, and with the density of the electric current therethrough as between 1 A/dm² and 8 A/dm² for between three minutes and ten minutes.

Moreover, even in a case where such the temperature of the solution therefor and the density of the electric current therethrough are individually within each of the above mentioned range thereof respectively, it is found out that there becomes a tendency that it becomes unable to form the protrusion as the fine bump shape thereon due to the quantity of the fine particles of copper to be formed on the surface of the copper plate as excessively smaller in the case where the amount of time for such the anodic treatment therefor is shorter than three minutes. Further, in the case where the amount of time for such the anodic treatment therefor is longer than ten minutes, it is found out that there becomes a tendency that it becomes unable to form the protrusion as the fine bump shape thereon in a preferred way due to the quantity of the fine particles of copper to be formed on the surface of the copper plate as excessively larger. Hence, it is desirable for such the amount of time for the anodic treatment therefor to be as between four minutes and eight minutes, and it is further preferable therefor to be as between four minutes and six minutes.

Still further, even in a case where such the temperature of the solution therefor and the amount of time for processing thereof are individually within each of the above mentioned range thereof respectively, it is found out that there becomes a tendency that it becomes unable to form the protrusion as the fine bump shape thereon due to the quantity of the fine particles of copper to be formed on the surface of the copper plate as excessively smaller in the case where the density of the electric current therethrough is lower than 1 A/dm². Still further, in the case where the density of the electric current therethrough is higher than 8 A/dm², it is found out that there becomes a tendency that it becomes unable to form the protrusion as the fine bump shape thereon in a preferred way, because there becomes to be occurred a peeling off at such as an end face thereof or the like due to the quantity of the fine particles of copper to be formed on the surface of the copper plate as excessively larger. Hence, it is desirable for such the density of the electric current therethrough according to such the anodic treatment therefor as between 1 A/dm² and 8 A/dm², and it is further preferable therefor to be as between 1 A/dm² and 5 A/dm².

Still further, even in a case where such the density of the electric current therethrough and the amount of time for processing thereof are individually within each of the above mentioned range thereof respectively, it is found out that there becomes a tendency that it becomes unable to form the protrusion as the fine bump shape thereon due to the quantity of the fine particles of copper to be formed on the surface of the copper plate as excessively smaller in the case where the temperature of the solution therefor is lower than 18 °C. Furthermore, in the case where the temperature of the solution therefor is higher than 32 °C, it is found out that there becomes a tendency that it becomes unable to form the protrusion as the fine bump shape thereon in a preferred way due to the quantity of the fine particles of copper to be formed on the surface of the copper plate as excessively larger.

### (Conditions of the cathodic treatment)

Here, there are determined conditions of such the cathodic treatment therefor according to an experiment as well. And then because there is designed for such the cathodic treatment therefor to be performed in the solution for the plating of copper as similar to that for the anodic treatment therefor, a temperature of such a solution is similar to the case of the anodic treatment therefor. Moreover, regarding an amount of time for processing thereof, with taking into consideration of performing such the anodic treatment therefor and the cathodic treatment therefor at the same time thereof, it is desirable therefor to be as similar to the case of the anodic treatment therefor. On the contrary thereto, the point as different from the case of the anodic treatment therefor is regarding a density of an electric current therethrough. Here, it is all right for such the cathodic treatment therefor if it is performed with the density of the electric current therethrough as between 1 A/dm² and 8 A/dm². Moreover, it is found out that there becomes a tendency that it becomes unable to fix the protrusion as the fine bump shape on the surface of the copper plate in a sufficient way due to the amount of the plating of copper thereon as excessively smaller in the case where such the density of the electric current therethrough is lower than 1 A/dm². Further, in the case where the density of the electric current therethrough is higher than 8 A/dm², it is found out that there becomes a tendency that it becomes unable to form the protrusion as the fine bump shape thereon in a preferred way, because there becomes to be covered such the protrusion as the fine bump shape by a layer to be plated thereon due to the amount of the plating of copper thereon as excessively larger. Hence, it is desirable for such the density of the electric current therethrough according to such the cathodic treatment therefor as between 1 A/dm² and 8 A/dm², and it is further preferable therefor to be as between 1 A/dm² and 5 A/dm².

### (Regarding the protrusion as the fine bump shape)

Here, the protrusion as the bump shape thereon means a form to be precipitated, such as attaching to each other with having a necking (constricted part) at between a base for the plate of copper and a particle or at between a particle and another particle. And then according to such the necking therebetween, there becomes to be functioned an effect of anchoring with between a resin of an insulating substrate. Hence, it becomes able to be improved thereby a strength of adhesive bonding for therebetween. Moreover, such the form includes a case where there becomes to be a bump as a cluster shape (a bunch shape of grapes) by attaching the particles to each other, that a size thereof becomes to be as approximately between 1 µm and 20 µm. Further, it is not necessary for all of such the protrusion thereon to be as the bump shape, and there is included in such the protrusion as the bump shape thereon, if it satisfies a particle size thereof and a grain size thereof, that will be described later, even in a case where there are existed together a protrusion thereon, that does not have any necking at all, and the protrusion as the bump shape thereon.

Still further, regarding the grain size of such the protrusion as the bump shape thereon, it is desirable therefor to be as not larger than 10 µm, because there becomes to be better the adherence of between such the protrusion and the base for the plate of copper in such the range thereof, and because there becomes to be better the strength of adhesive bonding with between the insulating substrate therein as well. Still further, in a case where the grain size of such the protrusion of the fine bump shape is between 0.5 µm and 3 µm, there becomes to be further preferable because there becomes to be enhanced a uniformity thereof and then thereby because there becomes to be further improved the strength of adhesive bonding for between such the protrusion and the base therefor.

Still further, there is provided an Rz as a roughness that it is able to be measured as macroscopically. And then it is desirable for such the Rz thereon to be as between 3 µm and 20 µm, because there becomes to be better the adherence of between such the protrusion and the base therefor in such the range thereof, and because there becomes to be better the strength of adhesive bonding with between the insulating substrate therein as well. Still further, it becomes to be further preferable in a case where such the Rz thereon is between 7 µm and 16 µm, because there becomes to be enhanced a uniformity thereof and then thereby because there becomes to be further improved the strength of adhesive bonding for between such the particles and the base therefor.

However, it is hard to perform such the measurement of the roughness at an inner face of a hole. Hence, it may be all right to be roughened at such the inner face of the hole. Still further, it may be all right if there is not happened for a diameter of such the hole to be smaller than that according to a regulation therefor due to an abnormal growth of any of the bumps thereon, or if there is not happened for any of the bumps thereon to be peeled off at a period of accumulating the insulating substrate. Still further, regarding a height of such the bump (in a case of a cluster shape thereof, it is considered that a height regarding a whole of such the cluster thereof is defined to be a height of the bump), it is desirable therefor to be as not higher than 20 µm. And then in such the range thereof, there is not happened at all for any of the holes to be smaller in the diameter thereof, there is not happened at all for any of the bumps thereon to be peeled off therefrom, or the like.

Still further, according to all of the processes therefor as described above, it may be available to make use of a jig as arbitrary with corresponding to the requirement therefor, for performing a holding of the plate of copper to be performed roughening the surface thereof. Still further, it is desirable for such the jig to be made of a metal, such as copper, an alloy of copper, a stainless metal, titanium, or the like. Furthermore, regarding the value of the electric current therethrough to be required for such the processes thereof, there becomes to be consumed such the electric current therethrough for such the processes thereof even on the surface of the metal as such the jig itself therefor. And then thereby it is necessary to be set such the value of the electric current therethrough to be required for such the processes thereof, by adding an amount of an area for the surface of the metal as such the jig therefor, that is steeped in the solution for the process thereof, to the area of the surfaces of the plate to be processed thereby.

### Examples

Here, the plate of copper that is made use for each of the present examples is a rolled plate of tough pitch copper with having a dimension of 500 mm as a length thereof, 380 mm as a width thereof, and 400 µm or 200 µm as a thickness thereof. Moreover, for such the plate of copper with having the thickness of 400 µm, there is made use of a member for which there is performed processes of drilling to produce holes for through holes that individually have inner diameters of between 1 mm and 2 mm respectively, with a number thereof for a total of areas of such the holes to be as 10 % of the area of the plate (each of the locations of such the holes is arbitrary). Further, regarding such the plate of copper with having the thickness of 200 µm, there is performed each of the processes therefor with overlapping such the plates as two sheets thereof, and then there becomes to obtain the copper plates to be roughened one side of the individual surfaces thereof, and then thereafter there is designed for such the plate to be made use for a peel test.

Still further, a composition of the electroplating solution therefor to be made use for the processes thereof is: sulfate of copper as 90 g/l; sulfuric acid as 180 g/l; and hydrochloric acid as 60 ppm. Still further, there is added a brightening agent and a restraining agent as the supplementary agents thereinto respectively, that are made use for a plating of bright copper in general, with a quantity to be specified by a maker therefor respectively. Furthermore, it is available to be provided as an example of a commercial product for such the brightening agent therefor and such the restraining agent therefor, such as the series of the COPPER GLEAM™ that is the brightening agent for a copper sulfate plating which is produced by Rohm and Haas Company, the series of the KUPPELIGHT™, the series of the PYRONIKKA™, that are individually produced by Nihon Kagaku Sangyo Co., Ltd., or the like. And then it may be available to be selected from such the agents therefor as required with corresponding to a type of the bath therefor, a substance for the electrodes therefor, an object to make use of the final product, or the like.

### (Example 1)

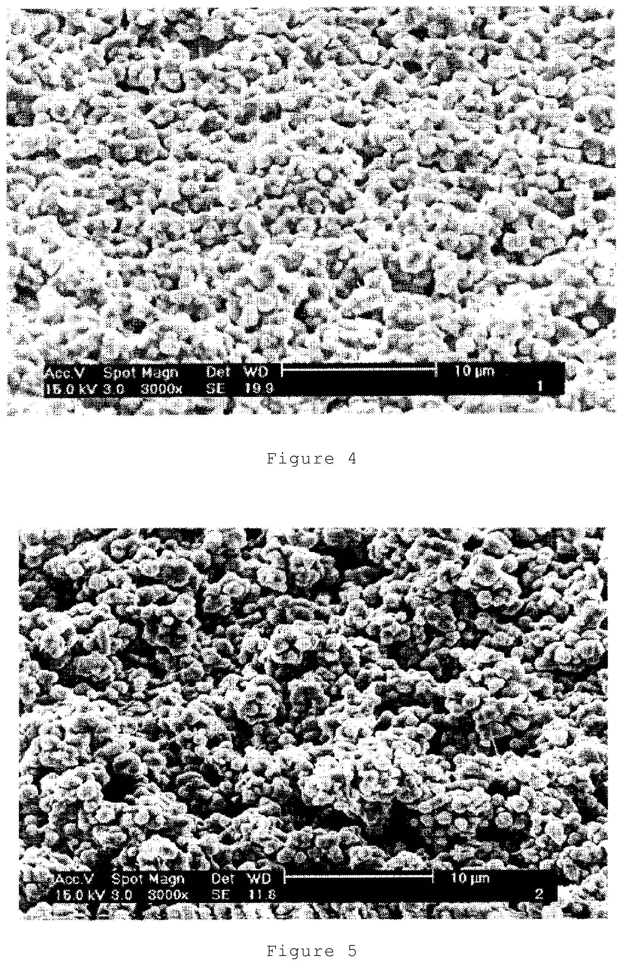

First of all, there is designed to be performed an anodic treatment for each of the plates of copper that individually have the thickness of 400 µm and 200 µm respectively, with a temperature of the solution therefor as 28 °C, and with a density of an electric current therethrough as 4.5 A/dm² for approximately five minutes for each thereof. And then thereafter there is designed to be performed a cathodic treatment for each thereof, with the temperature of the solution therefor as similar thereto, and with a density of an electric current therethrough as 1.4 A/dm² for approximately five minutes for each thereof. Hence, there becomes to be produced a copper plate to be roughened a surface thereof. Moreover, there is shown a state of the surface of such the copper plate to be roughened the surface thereof in FIG. 4 (with a multiplying factor of 3000 times therefor according to the SEM). Further, according to such the figure, it becomes clear that the grain size of the protrusion as the fine bump shape on the primary surface thereof is not larger than 3 µm, and that there becomes to be covered substantially all over the surface thereof uniformly with such the protrusion as the fine bump shape thereon. Still further, there becomes able to be recognized thereby that there is a part thereon to become the bump shape as the cluster shape, however, each of the grain size of such the part thereon and the height thereof is not more than 10 µm respectively.

Still further, there is designed to be measured the surface roughness thereof by making use of the microscope of color 3D for super deep shape measurement as the type of VK-9510, that is produced by KEYENCE CORPORATION. And then according thereto, the surface roughness thereof as the Rz becomes to be 7.5 µm.

Still further, regarding the shape of such the protrusion as the fine bump shape thereon, it is not able to be recognized any difference at all for between that on the plate of copper with having the thickness of 400 µm and that on the plate of copper with having the thickness of 200 µm.

Still further, there is designed for such the copper plate to be roughened the surface thereof to be attached a cellophane tape that is on the market and has a width of 10 mm approximately, and then thereafter there is designed the same to be performed a pulling off test therefor. As a result thereof, there is not found any peeling off of such the protrusion as the fine bump shape thereon at all, but there becomes to be peeled off only the adhesive agent of the cellophane tape from the interface of such the cellophane tape, and then there becomes to be remained such the adhesive agent of the cellophane tape on such the copper plate to be roughened the surface thereof.

Next, there is designed to be laminated glass epoxy prepreg of FR-4 (a substance for an insulating substrate) as ten sheets thereof, that is on the market and has a thickness of 0.1 mm, on a copper plate to be roughened one side of the surfaces thereof with having the thickness of 200 µm. And then thereafter there is designed to be integrated such the sheets thereof by pressing with heating according to a condition as similar to the condition of performing a hot pressing for between the electrolytic copper foil and the FR-4 prepreg. Hence, there becomes to be obtained a laminated plate that is comprised of the copper plate and the insulating plate. Still further, there is designed to be cut out a sample from such the laminated plate, and then thereafter there is designed to be performed a test for a strength against peeling therefrom, that is pursuant to the JIS-C6471, regarding such the actual sample and regarding the other sample after performing a soaking into a solder to be molten at a temperature of 260 °C for sixty seconds approximately. Still further, there is shown a result according thereto in Table 1. Furthermore, there becomes to be obtained such the strength against peeling therefrom, with sufficiently satisfying the strength of adhesive bonding for between the metal core and the insulating substrate, that is required for a metal core substrate for a circuit board (as not weaker than 1 kN/m).

**(Table 1)**

| Initial stage (before performing a process for the solder to be heat resistant) (kN/m) | | | | | | | | |
|---|---|---|---|---|---|---|---|---|
| Location of the measurement | Upper side at center | Lower side at center | Upper side at right end | Center at right end | Lower side at right end | Upper side at left end | Center at left end | Lower side at left end |
| MIN | 2,2 | 2,4 | 2,3 | 2,1 | 2,2 | 2,7 | 2,3 | 2,4 |
| MAX | 2,5 | 2,4 | 2,9 | 2,7 | 2,5 | 2,9 | 2,8 | 3,0 |
| AVG | 2,4 | 2,4 | 2,5 | 2,6 | 2,3 | 2,4 | 2,5 | 2,6 |
| | | | | | | | | |

| After performing a process for the solder to be heat resistant at 260 °C for 60 seconds (kN/m) | | | | | | | | |
|---|---|---|---|---|---|---|---|---|
| Location of the measurement | Upper side at center | Lower side at center | Upper side at right end | Center at right end | Lower side at right end | Upper side at left end | Center at left end | Lower side at left end |
| MIN | 2,1 | 2,2 | 2,1 | 2,0 | 2,0 | 2,5 | 2,3 | 2,2 |
| MAX | 2,4 | 2,5 | 2,5 | 2,4 | 2,2 | 2,6 | 2,5 | 2,6 |
| AVG | 2,3 | 2,4 | 2,4 | 2,3 | 2,4 | 2,5 | 2,4 | 2,4 |
| | Location of the measurement Upper edge of the copper plate to be roughened | | | | | | | |
| | Upper side at left end | | Upper side at center | | Upper side at right end | | | |
| | Center at left end | | | | Center at right end | | | |
| | | | Lower side at center | | | | | |
| | Lower side at left end | | | | Lower side at right end | | | |
| | Lower edge of the copper plate to be roughened | | | | | | | |

### (Example 2)

First of all, there is designed to be performed an anodic treatment for each of the plates of copper that individually have the thickness of 400 µm and 200 µm respectively, with a temperature of the solution therefor as 24 °C, and with a density of an electric current therethrough as 4.5 A/dm² for approximately five minutes for each thereof. And then thereafter there is designed to be performed a cathodic treatment for each thereof, with the temperature of the solution therefor as similar thereto, and with a density of an electric current therethrough as 2 A/dm² for approximately five minutes for each thereof. Moreover, there is defined such the processes as one cycle thereof, and then thereby there is designed to be performed such the processes as two cycles thereof. Hence, there becomes to be produced a copper plate to be roughened a surface thereof. Further, there is shown a state of the surface of such the copper plate to be roughened the surface thereof in FIG. 5 (with a multiplying factor of 3000 times therefor according to the SEM). Still further, according to such the figure, it becomes clear that the grain size of the protrusion as the fine bump shape on the primary surface thereof is not larger than 3 µm, and that there becomes to be covered substantially all over the surface thereof uniformly with such the protrusion as the fine bump shape thereon. Still further, there becomes able to be recognized thereby that there is a part thereon to become the bump shape as the cluster shape, however, each of the grain size of such the part thereon and the height thereof is not more than 10 µm respectively.

Still further, there is designed to be measured the surface roughness thereof by making use of the microscope of color 3D for super deep shape measurement as the type of VK-9510, that is produced by KEYENCE CORPORATION. And then according thereto, the surface roughness thereof as the Rz becomes to be 11.0 µm.

Still further, there is designed for such the copper plate to be roughened the surface thereof to be attached a cellophane tape that is on the market and has the width of 10 mm approximately, and then thereafter there is designed the same to be performed a pulling off test therefor. As a result thereof, there is not found any peeling off of such the protrusion as the fine bump shape thereon at all, but there becomes to be peeled off only the adhesive agent of the cellophane tape from the interface of such the cellophane tape, and then there becomes to be remained such the adhesive agent of the cellophane tape on such the copper plate to be roughened the surface thereof.

Next, there is designed to be laminated a prepreg as similar to that according to Example 1 on a copper plate to be roughened one side of the surfaces thereof with having the thickness of 200 µm. And then thereafter there is designed to be performed the process of pressing with heating according to the condition as similar thereto. Hence, there becomes to be obtained a laminated plate that is comprised of the copper plate and the insulating plate. Still further, there is designed to be performed thereafter a test for a strength against peeling therefrom regarding such the laminated plate as similar to that according to Example 1. Still further, there is shown a result according thereto in Table 2. Furthermore, there becomes to be obtained such the strength against peeling therefrom, with sufficiently satisfying the strength of adhesive bonding for between the metal core and the insulating substrate, that is required for the metal core substrate for the circuit board (as not weaker than 1 kN/m).

**(Table 2)**

| Initial stage (before performing a process for the solder to be heat resistant) (kN/m) | | | | | | | | |
|---|---|---|---|---|---|---|---|---|
| Location of the measurement | Upper side at center | Lower side at center | Upper side at right end | Center at right end | Lower side at right end | Upper side at left end | Center at left end | Lower side at left end |
| MIN | 3,3 | 3,3 | 3,0 | 3,0 | 3,2 | 2,7 | 3,1 | 3,1 |
| MAX | 3,5 | 3,6 | 3,2 | 3,2 | 3,5 | 2,9 | 3,4 | 3,5 |
| AVG | 3,4 | 3,4 | 3,1 | 3,1 | 3,3 | 2,8 | 3,2 | 3,3 |
| | | | | | | | | |

| After performing a process for the solder to be heat resistant at 260 °C for 60 seconds (kN/m) | | | | | | | | |
|---|---|---|---|---|---|---|---|---|
| Location of the measurement | Upper side at center | Lower side at center | Upper side at right end | Center at right end | Lower side at right end | Upper side at left end | Center at left end | Lower side at left end |
| MIN | 3,4 | 3,2 | 3,0 | 3,1 | 3,0 | 3,4 | 3,3 | 3,4 |
| MAX | 3,7 | 3,5 | 3,2 | 3,4 | 3,2 | 3,7 | 3,7 | 3,6 |
| AVG | 3,5 | 3,3 | 3,1 | 3,3 | 3,1 | 3,6 | 3,5 | 3,4 |

### (Example 3)

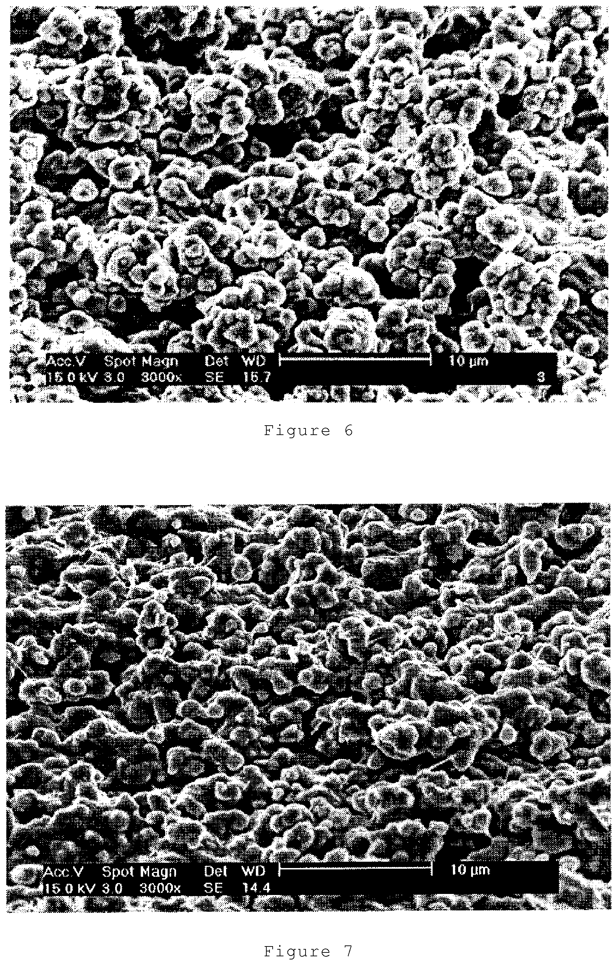

First of all, there is designed to be performed an anodic treatment for each of the plates of copper that individually have the thickness of 400 µm and 200 µm respectively, with a temperature of the solution therefor as 32 °C, and with a density of an electric current therethrough as 2 A/dm² for approximately five minutes for each thereof. And then thereafter there is designed to be performed a cathodic treatment for each thereof, with the temperature of the solution therefor as similar thereto, with a density of an electric current therethrough as similar thereto, and with an amount of time therefor as similar thereto as well. Moreover, there is defined such the processes as one cycle thereof, and then thereby there is designed to be performed such the processes as two cycles thereof. Hence, there becomes to be produced a copper plate to be roughened a surface thereof. Further, there is shown a state of the surface of such the copper plate to be roughened the surface thereof in FIG. 6 (with a multiplying factor of 3000 times therefor according to the SEM). Still further, according to such the figure, it becomes clear that the grain size of the protrusion as the fine bump shape on the primary surface thereof is not larger than 3 µm, and that there becomes to be covered substantially all over the surface thereof uniformly with such the protrusion as the fine bump shape thereon. Still further, there becomes able to be recognized thereby that there is a part thereon to become the bump shape as the cluster shape, however, each of the grain size of such the part thereon and the height thereof is not more than 10 µm respectively.

Still further, there is designed to be measured the surface roughness thereof by making use of the microscope of color 3D for super deep shape measurement as the type of VK-9510, that is produced by KEYENCE CORPORATION. And then according thereto, the surface roughness thereof as the Rz becomes to be 15.0 µm.

Still further, there is designed for such the copper plate to be roughened the surface thereof to be attached a cellophane tape that is on the market and has the width of 10 mm approximately, and then thereafter there is designed the same to be performed a pulling off test therefor. As a result thereof, there is not found any peeling off of such the protrusion as the fine bump shape thereon at all, but there becomes to be peeled off only the adhesive agent of the cellophane tape from the interface of such the cellophane tape, and then there becomes to be remained such the adhesive agent of the cellophane tape on such the copper plate to be roughened the surface thereof.

Next, there is designed to be laminated a prepreg as similar to that according to Example 1 on a copper plate to be roughened one side of the surfaces thereof with having the thickness of 200 µm. And then thereafter there is designed to be performed the process of pressing with heating according to the condition as similar thereto. Hence, there becomes to be obtained a laminated plate that is comprised of the copper plate and the insulating plate. Still further, there is designed to be performed thereafter a test for a strength against peeling therefrom regarding such the laminated plate as similar to that according to Example 1. As a result thereof, there becomes to be obtained the minimum value for all over such the plate as 2.1 kN/m, the maximum value therefor as 3.1 kN/m, and the mean value therefor as 2.5 kN/m. Still further, regarding the strength against peeling therefrom after performing the process for the solder to be heat resistant, there becomes to be obtained the minimum value for all over such the plate as 1.9 kN/m, the maximum value therefor as 2.8 kN/m, and the mean value therefor as 2.4 kN/m. Furthermore, there becomes to be obtained such the strength against peeling therefrom, with sufficiently satisfying the strength of adhesive bonding for between the metal core and the insulating substrate, that is required for the metal core substrate for the circuit board (as not weaker than 1 kN/m).

### (Example 4)

First of all, there is designed to be performed an anodic treatment for each of the plates of copper that individually have the thickness of 400 µm and 200 µm respectively, with a temperature of the solution therefor as 22 °C, and with a density of an electric current therethrough as 2 A/dm² for approximately five minutes for each thereof. And then thereafter there is designed to be performed a cathodic treatment for each thereof, with the temperature of the solution therefor as similar thereto, with a density of an electric current therethrough as similar thereto, and with an amount of time therefor as similar thereto as well. Moreover, there is defined such the processes as one cycle thereof, and then thereby there is designed to be performed such the processes as two cycles thereof. Hence, there becomes to be produced a copper plate to be roughened a surface thereof. Further, there is shown a state of the surface of such the copper plate to be roughened the surface thereof in FIG. 7 (with a multiplying factor of 3000 times therefor according to the SEM). Still further, according to such the figure, it becomes clear that the grain size of the protrusion as the fine bump shape on the primary surface thereof is not larger than 5 µm, and that there becomes to be covered substantially all over the surface thereof uniformly with such the protrusion as the fine bump shape thereon. Still further, there becomes able to be recognized thereby that there is a part thereon to become the bump shape as the cluster shape, however, each of the grain size of such the part thereon and the height thereof is not more than 10 µm respectively.

Furthermore, there is designed to be measured the surface roughness thereof by making use of the microscope of color 3D for super deep shape measurement as the type of VK-9510, that is produced by KEYENCE CORPORATION. And then according thereto, the surface roughness thereof as the Rz becomes to be 4.0 µm.

### (Examples 5 to 7)

First of all, there is designed to be formed holes as a plurality thereof individually for the through holes on a plate of copper for a core that has a thickness of between 200 µm and 400 µm by making use of a drill, with having individual diameters of between 3 mm and 5 mm respectively. Moreover, it may be available to be formed such the holes by punching out with making use of a press machine, because there may become to be required such the holes as a significant number thereof that may depend on a specification of a design for a substrate.

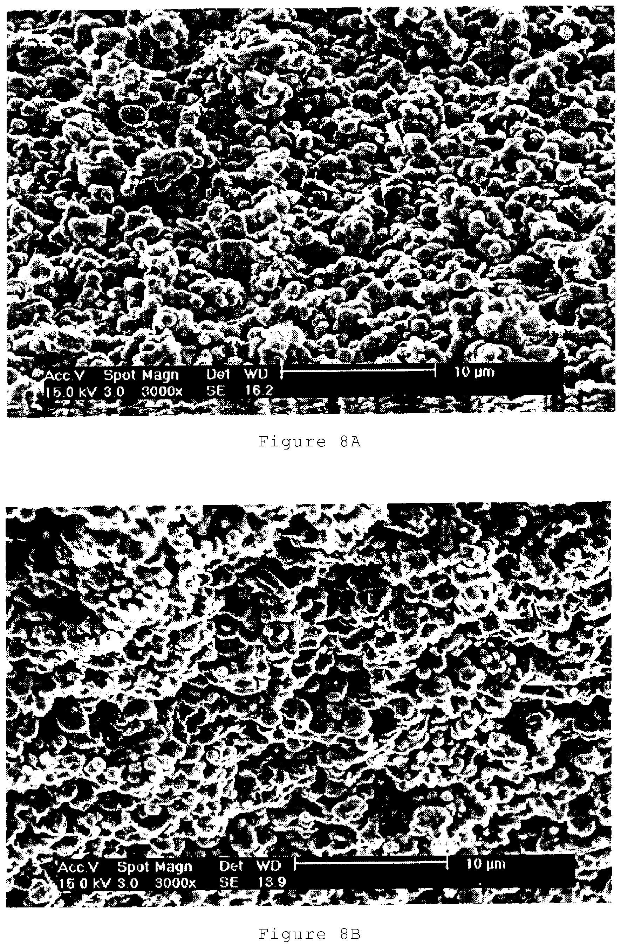

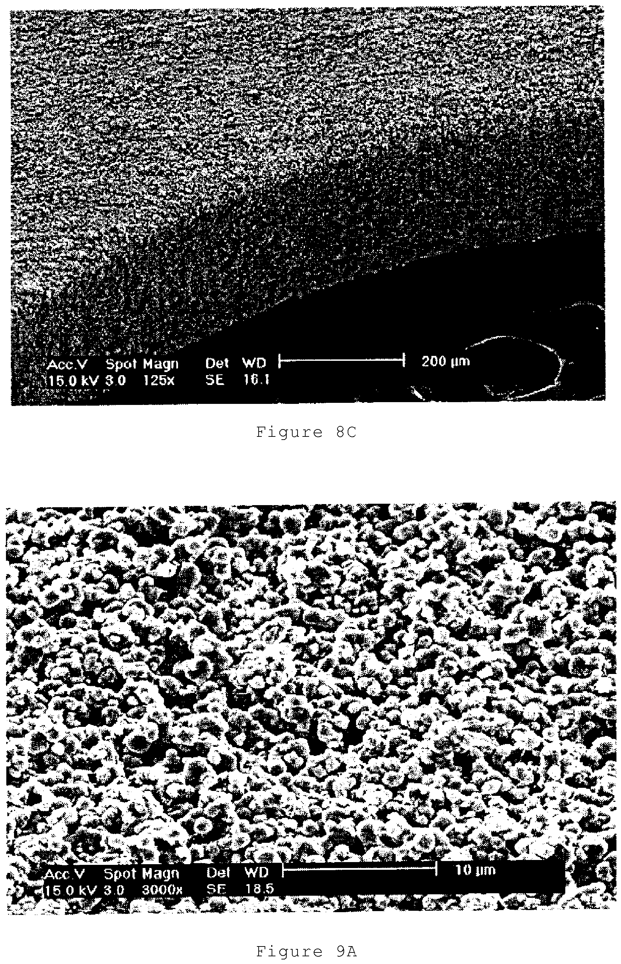

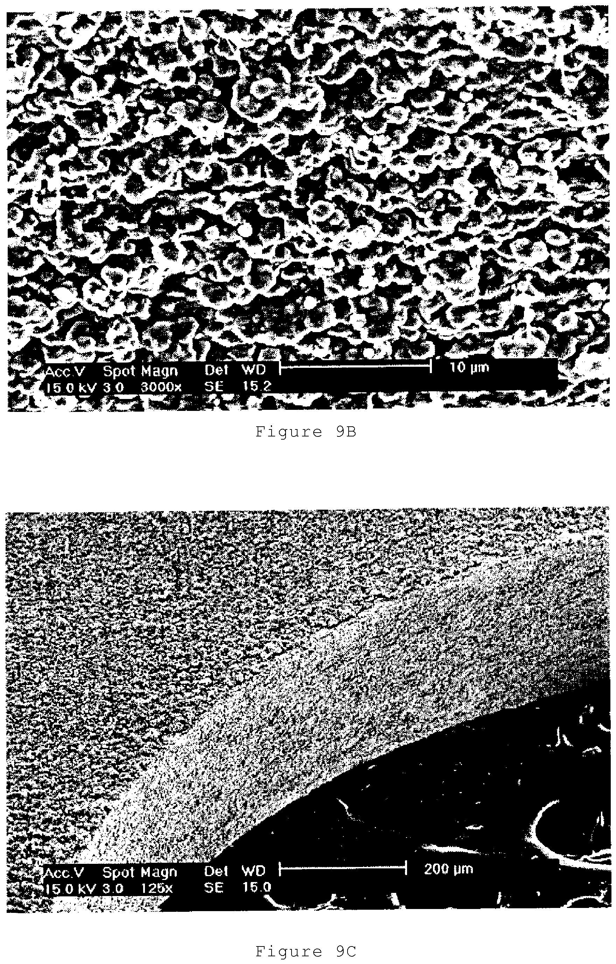

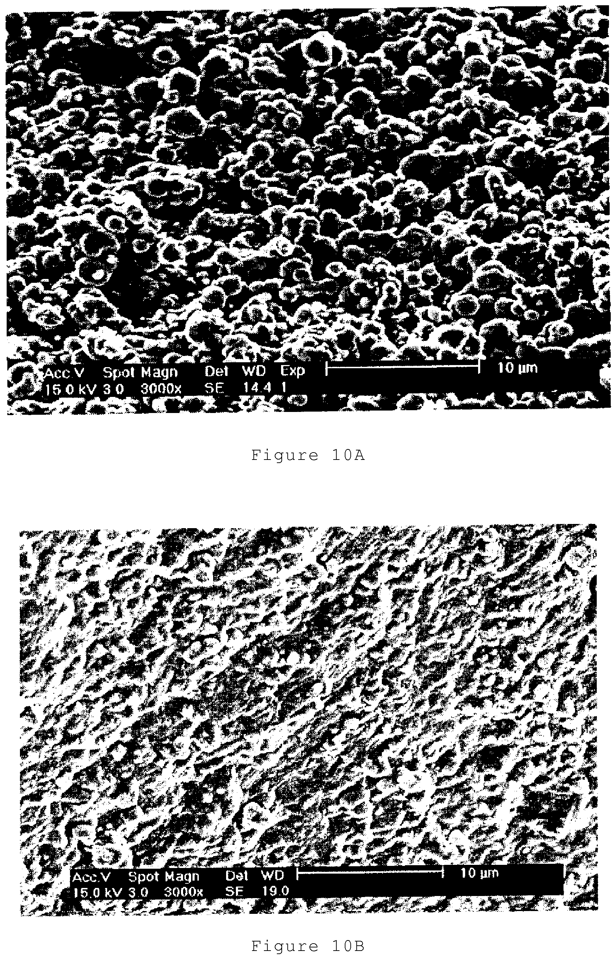

And then thereafter, there is designed to be formed the protrusion as the fine bump shape on the surfaces that includes the inner face of such the individual holes by making use of the processes for producing such the protrusion according to the present invention. As a result thereof, it becomes able to be obtained a copper plate to be roughened a surface thereof, that there becomes to be formed uniformly such the protrusion as the fine bump shape not only on the primary surface of such the copper plate but also including the protrusion at the inner face of such the individual holes as well, comparing to the plate to be formed by making use of the processes for producing the same according to the comparative example that will be described later. Further, there are shown each of the states of the individual surfaces of such the copper plates to be roughened the surfaces thereof in FIG. 8 to FIG. 10 respectively, wherein each of (A) shows the primary surface thereof with a multiplying factor of 3000 times therefor according to the SEM respectively, each of (B) shows an inner face of a hole thereon with a multiplying factor of 3000 times therefor according to the SEM respectively, and each of (C) shows an edge part of a hole thereon with a multiplying factor of 125 times therefor according to the SEM respectively.

Still further, according to Example 5, it becomes clear that the grain size of the protrusion as the fine bump shape on the primary surface thereof is not larger than 3 µm, and that there is a part thereon to become the bump shape as the cluster shape, and then that each of the grain size of such the part thereon and the height thereof is not more than 10 µm respectively. Still further, it becomes clear that the surface roughness thereof as the Rz becomes to be 8.0 µm. Still further, there becomes to be roughened the inner face of such the hole thereon as well, and then it becomes clear that the height of such the protrusion as the bump shape at such the inner face thereof is not higher than 15 µm respectively.

Still further, according to Example 6, it becomes clear that the grain size of the protrusion as the fine bump shape on the primary surface thereof is not larger than 3 µm, and that there is a part thereon to become the bump shape as the cluster shape, and then that each of the grain size of such the part thereon and the height thereof is not more than 10 µm respectively. Still further, it becomes clear that the surface roughness thereof as the Rz becomes to be 7.0 µm. Still further, there becomes to be roughened the inner face of such the hole thereon as well, and then it becomes clear that the height of such the protrusion as the bump shape at such the inner face thereof is not higher than 10 µm respectively.

Still further, according to Example 7, it becomes clear that the grain size of the protrusion as the fine bump shape on the primary surface thereof is not larger than 3 µm, and that there is a part thereon to become the bump shape as the cluster shape, and then that each of the grain size of such the part thereon and the height thereof is not more than 10 µm respectively. Still further, it becomes clear that the surface roughness thereof as the Rz becomes to be 11.0 µm. Still further, there becomes to be roughened the inner face of such the hole thereon as well, and then it becomes clear that the height of such the protrusion as the bump shape at such the inner face thereof is not higher than 5 µm respectively.

And then thereafter there is designed to be laminated glass epoxyprepreg (a substance for an insulating substrate) as a plurality of sheets therefor onto the copper plate to be roughened the surface thereof with having the holes that is obtained according to such the processes therefor, and then thereafter there is designed to be integrated such the sheets thereof by pressing with heating therefor. Still further, there is designed to be removed a portion of such the substance for the insulating substrate at each of the locations for the through holes thereon. And then thereafter there is designed to be performed a plating therefor at around the circumference thereof. As a result thereof, it becomes able to obtain a circuit board that there becomes to be formed the through holes with having individual diameters of approximately 1 mm respectively.

And then as a result of performing a test with applying a highvoltage (1000 V) to such the finished product, it becomes clear that it becomes able to be maintained a nonconductivity as sufficiently for between such the individual through holes and the core, and that it becomes able to function a performance thereof as excellently. Furthermore, it becomes clear that there is not found out any peeling off of the resin or any of cracks thereof at all from the core at around each of such the through holes even after performing the test for the solder to be heat resistant, and then thereby that the adherence between such the core and the resin is excellent as preferred thereto.

### (Example 8)

Here, there is designed to be produced a copper plate to be roughened a surface thereof as similar to the processes according to Example 1 to 4, and then there is designed to be formed thereafter a protrusion as a fine bump shape on a primary surface thereof. And then thereafter there is designed to be performed a processing for forming a hole for a through hole on such the plate of copper. Moreover, there becomes to be obtained a circuit board that is comprised of insulating substrates to be laminated, as similar to the processes according to Example 5.

As a result according to such the present example, there is found out at round the circumference of a hole thereon at a period of performing a process of drilling therefor by making use of a drill or a punch, such as a portion to be collapsed that is roughened beforehand thereof, a particle of bump shape to be peeled off therefrom, an appearance thereof as not to be uniform, or the like. Further, there becomes to be attached an oil for processing at a period of punching therefor, and then thereby there becomes to be required sometimes further process of additional washing therefor. Furthermore, there becomes not to be roughened at each of the inner faces of the individual holes thereon, and then thereby it becomes to be suspected that there may become to be obtained an adherence for between the resin as weaker at each of such the inner faces of the individual holes thereon. However, it becomes able to be obtained an adherence therefor at the primary surface thereof, and then thereby it becomes able to be made use thereof, without finding any problem at all regarding the nonconductivity thereof.

### (Comparative example 1)

Here, there is designed to be performed an anodic treatment for the above mentioned plate of copper, with a temperature of the solution therefor as 25 °C, and with a density of an electric current therethrough as 8.5 A/dm² for approximately five minutes. And then thereafter there is designed to be performed a cathodic treatment therefor, with a temperature of the solution therefor as similar thereto, with a density of an electric current therethrough as similar thereto, and with an amount of time therefor as similar thereto as well. Hence, there becomes to be produced a copper plate to be roughened a surface thereof. Moreover, in such the case thereof, it becomes able to be roughened a center part of such the plate as excellently, however, there becomes to be progressed excessively a dissolution at an end part of such the plate due to an electrolysis therein because of the density of the electric current therethrough as excessively higher therefor. Further, there becomes to be performed such the plating excessively as too much thereon, and then thereby there becomes to be whitened to the utmost. As a result thereof, there becomes to be happened an unevenness for all over the surface of such the plate, and then thereby it becomes unable to be made use of such the plate for a metal core.

### (Comparative example 2)

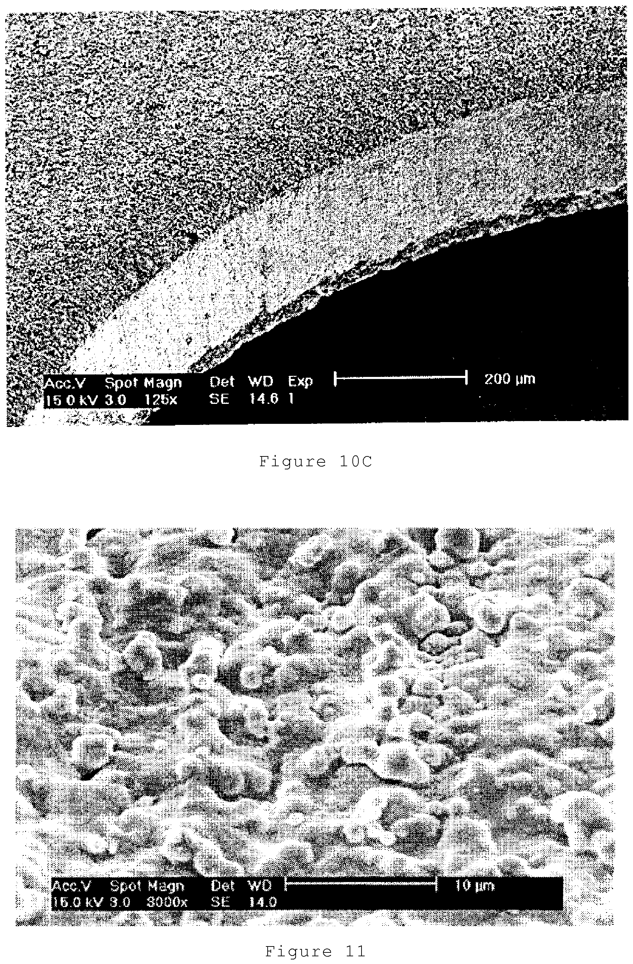

Here, there is designed to be performed an anodic treatment for the above mentioned plate of copper, with a temperature of the solution therefor as 25 °C, and with a density of an electric current therethrough as 0.9 A/dm² for approximately ten minutes. And then thereafter there is designed to be performed a cathodic treatment therefor, with a temperature of the solution therefor as similar thereto, with a density of an electric current therethrough as similar thereto, and with an amount of time therefor as similar thereto as well. Hence, there becomes to be produced a copper plate to be roughened a surface thereof. Moreover, there is shown a state of the surface of such the copper plate to be roughened the surface thereof in FIG. 11 (with a multiplying factor of 3000 times therefor according to the SEM). Further, in such the case thereof, it is found out that there is not progressed to be roughened thereby for all over the surface thereof, and then that it is not able to be formed sufficiently the protrusion as the fine bump shape thereon. Furthermore, the surface roughness as the Rz on the primary surface thereof becomes to be 2.5 µm.

### (Comparative example 3)

Here, there is designed to be performed an anodic treatment for the above mentioned plate of copper, with a temperature of the solution therefor as 25 °C, and with a density of an electric current therethrough as 4.5 A/dm² for approximately eleven minutes. And then thereafter there is designed to be performed a cathodic treatment therefor, with a temperature of the solution therefor as similar thereto, with a density of an electric current therethrough as similar thereto, and with an amount of time therefor as similar thereto as well. Hence, there becomes to be produced a copper plate to be roughened a surface thereof. Moreover, in such the case thereof, it becomes able to be roughened a center part of such the plate as excellently, however, there becomes to be progressed excessively a dissolution at an end part of such the plate and at a hole for a through hole due to an electrolysis therein. Further, there becomes to be performed such the plating excessively as too much thereon, and then thereby there becomes to be whitened to the utmost. As a result thereof, there becomes to be happened an unevenness for all over the surface of such the plate, and then thereby it becomes unable to be made use of such the plate for a metal core.

### (Comparative example 4)

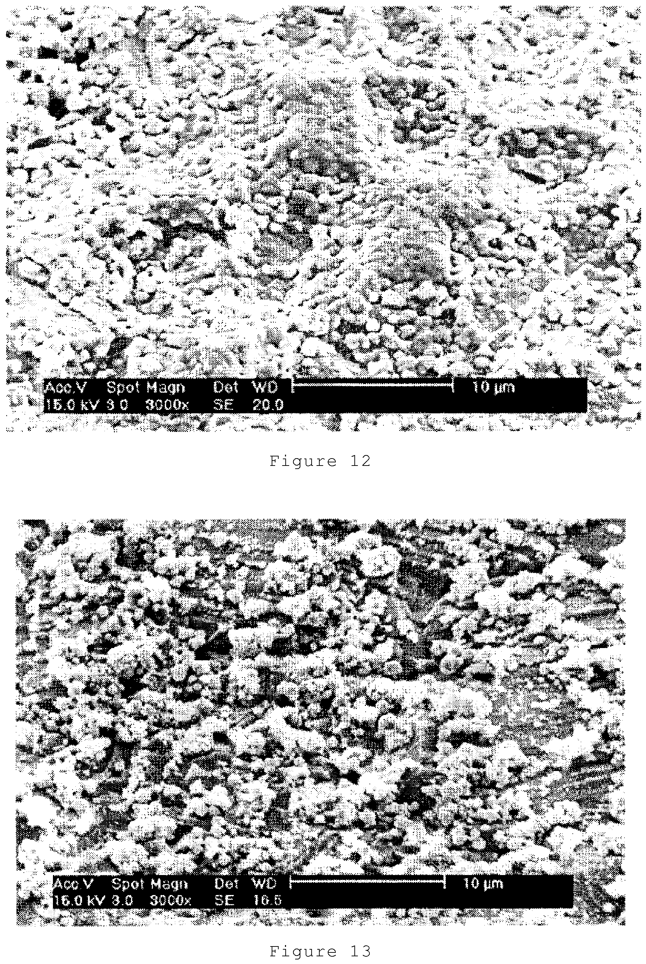

Here, there is designed to be performed an anodic treatment for the above mentioned plate of copper, with a temperature of the solution therefor as 25 °C, and with a density of an electric current therethrough as 4.5 A/dm² for approximately two and half minutes. And then thereafter there is designed to be performed a cathodic treatment therefor, with a temperature of the solution therefor as similar thereto, with a density of an electric current therethrough as 2 A/dm², and with an amount of time therefor as similar thereto as well. Hence, there becomes to be produced a copper plate to be roughened a surface thereof. Moreover, there is shown a state of the surface of such the copper plate to be roughened the surface thereof in FIG. 12 (with a multiplying factor of 3000 times therefor according to the SEM). Further, in such the case thereof, it is found out that there is not progressed to be roughened thereby for all over the surface thereof, and then that it is not able to be formed sufficiently the protrusion as the fine bump shape thereon. Furthermore, the surface roughness as the Rz on the primary surface thereof becomes to be 2.0 µm.

### (Comparative example 5)

Here, there is designed to be performed an anodic treatment for the above mentioned plate of copper, with a temperature of the solution therefor as 35 °C, and with a density of an electric current therethrough as 4.5 A/dm² for approximately five minutes. And then thereafter there is designed to be performed a cathodic treatment therefor, with a temperature of the solution therefor as similar thereto, with a density of an electric current therethrough as 1.4 A/dm², and with an amount of time therefor as similar thereto as well. Hence, there becomes to be produced a copper plate to be roughened a surface thereof. Moreover, in such the case thereof, there becomes to be occurred a burning of black color on the surface of such the copper plate due to cuprous oxide. Further, there is designed for such the copper plate to be roughened the surface thereof to be attached a cellophane tape that is on the market and has the width of 10 mm approximately, and then thereafter there is designed the same to be performed a pulling off test therefor. As a result thereof, there becomes to be peeled off such the part of the black color therefrom. And then thereby it becomes unable to be made use of such the plate for a metal core.

### (Comparative example 6)

Here, there is designed to be performed an anodic treatment for the above mentioned plate of copper, with a temperature of the solution therefor as 17 °C, and with a density of an electric current therethrough as 4.5 A/dm² for approximately ten minutes. And then thereafter there is designed to be performed a cathodic treatment therefor, with a temperature of the solution therefor as similar thereto, with a density of an electric current therethrough as similar thereto, and with an amount of time therefor as similar thereto as well. Hence, there becomes to be produced a copper plate to be roughened a surface thereof. Moreover, there is shown a state of the surface of such the copper plate to be roughened the surface thereof in FIG. 13 (with a multiplying factor of 3000 times therefor according to the SEM). Further, in such the case thereof, it is found out that there is not progressed to be roughened thereby for all over the surface thereof, and then that it is not able to be formed any of the protrusions as the fine bump shape thereon at all. And then thereby it becomes unable to be made use of such the plate for a metal core. Furthermore, the surface roughness as the Rz on the primary surface thereof becomes to be 1.8 µm.

### (Comparative example 7)

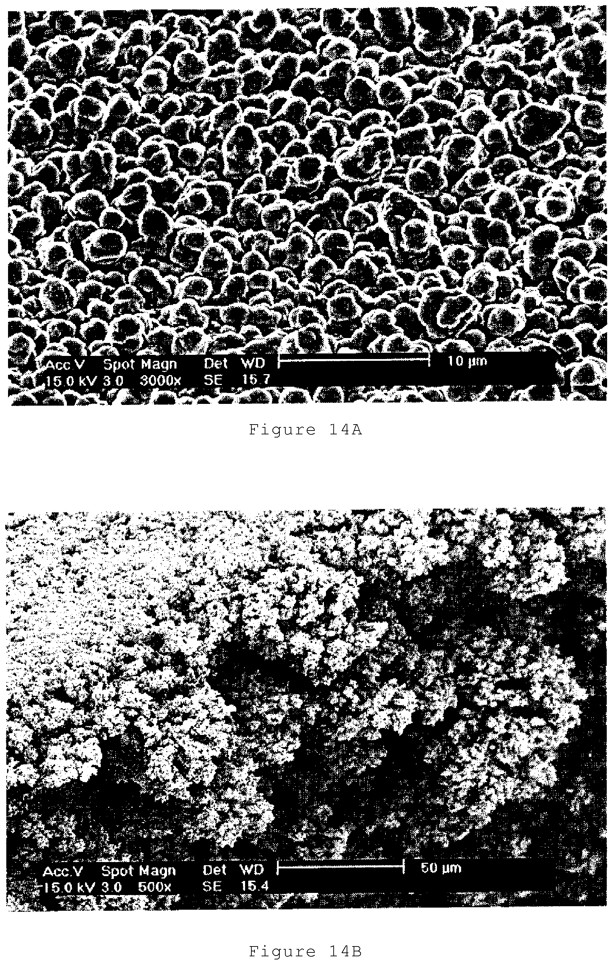

First of all, there is designed to be formed holes as a plurality thereof individually for the through holes on a plate of copper for a core that has a thickness of between 200 µm and 400 µm by making use of a drill, with having individual diameters of between 3 mm and 5 mm respectively. And then thereafter, there is designed to be formed the protrusion as the bump shape with having a diameter as several µm on the surfaces that includes the inner face of such the individual holes, by making use of the processes for producing such the protrusion according to the process of the conventional electroplating thereof. Moreover, there is shown a state of the surface of such the plate of copper in FIG. 14, wherein (A) shows the primary surface thereof with a multiplying factor of 3000 times therefor according to the SEM, (B) shows an inner face of a hole thereon with a multiplying factor of 500 times therefor according to the SEM, and (C) shows an inner face of a hole thereon with a multiplying factor of 125 times therefor according to the SEM. Further, it is found out that the grain size of the protrusion as the fine bump shape on the primary surface thereof is not larger than 5 µm, and that there is a part thereon to become the bump shape as the cluster shape, and then that each of the grain size of such the part thereon and the height thereof is not more than 10 µm respectively. Still further, it is found out that the surface roughness thereof as the Rz becomes to be 10.0 µm.

However, according to such the plate of copper, there becomes to be as not smaller than 20 µm for a size of the protrusion as the bump shape at the inner face thereof, that is a difference between a concave thereon and a convex thereon, comparing to that according to the primary surface thereof. Still further, even in the case of performing an adjustment of the condition for such the electroplating thereof, it becomes unable to form any of the protrusion as the bump shape as uniformly thereon with including such the two of the faces thereof.

Still further, a cause of such the matter is that there is designed to be made use of the density of the electric current as a larger amount therethrough according to such the process of the conventional electroplating thereof, and then thereby that there becomes to be convergent such the electric current as the larger amount from the electrode to each of the inner faces of the individual holes thereon, that have the surfaces with an area in total as smaller, at the places that each of such the holes passes therethrough comparing to other places on the surfaces of such the plate of copper that is designed to be faced to the electrode therefor.

Still further, there is designed to be adhered thereafter a substrate of resin thereon, and then there becomes to be produced a circuit board, as similar to that according to Example 5. Still further, there is designed to be performed a test with applying a high voltage (1000 V) to such the board. And then as a result thereof, it is found out that there is a case where it is not able to be maintained a nonconductivity for between such the individual through holes and the core.

Furthermore, according to an analysis therefor, it is found out that in addition to the problem on the adherence of therebetween, there becomes to be peeled off the protrusion of the fine particle of copper therefrom due to the pressure of pressing therefor, and then there becomes to be penetrated such the protrusion into the inside of the resin, at the period of the process of laminating the insulating substrate of resin, and then thereby that it becomes to be worsened the nonconductivity of therebetween, because there is not designed to be sufficiently enough for the distance for insulation of between the individual holes and the core. That is to say, it becomes clear that there becomes to be happened such the problems as mentioned above in the case of producing the copper plate to be roughened the surface thereof that the holes are opened thereon, by making use of such the process of the conventional electroplating thereof.

Thus, according to the above description, it becomes clear that regarding the plate of copper for the metal core that has any of the holes individually for the through holes in particular, it becomes able to form the protrusion as the fine bump shape on the surface of the copper plate, by making use of such the processes according to the present invention, after forming any of the holes on such the plate of copper, and then thereby that it becomes able to perform the process of roughening as uniformly for the surface thereof and for the inner face of any of the holes thereon, therefore that it is the optimum therefor.

### Brief description of the drawings

FIG. 1 is a view showing one embodiment according to the present invention, wherein (A) is a plan view, (B) is a cross sectional view from a view point of B-B line in (A), and (C) is a cross sectional view from a view point of C-C line in (B).
FIG. 2 is a view showing one embodiment as another one according to the present invention, wherein (A) is a plan view, (B) is a cross sectional view from a view point of B-B line in (A).
FIG. 3 is a view showing one embodiment as further another one according to the present invention, wherein (A) is a plan view, (B) is a cross sectional view from a view point of B-B line in (A).
FIG. 4 is a photo according to a scanning electron microscope showing a state of a surface on a copper plate to be roughened a surface thereof according to Example 1.
FIG. 5 is a photo according to a scanning electron microscope showing a state of a surface on a copper plate to be roughened a surface thereof according to Example 2.
FIG. 6 is a photo according to a scanning electron microscope showing a state of a surface on a copper plate to be roughened a surface thereof according to Example 3.
FIG. 7 is a photo according to a scanning electron microscope showing a state of a surface on a copper plate to be roughened a surface thereof according to Example 4.
FIG. 8A is a photo according to a scanning electron microscope showing a state of a surface on a copper plate to be roughened a surface thereof according to Example 5, wherein there is shown a primary surface thereof.
FIG. 8B is a photo according to a scanning electron microscope showing a state of a surface on a copper plate to be roughened a surface thereof according to Example 5, wherein there is shown an inner face of a hole thereon.
FIG. 8C is a photo according to a scanning electron microscope showing a state of a surface on a copper plate to be roughened a surface thereof according to Example 5, wherein there is shown an edge part of a hole thereon.
FIG. 9A is a photo according to a scanning electron microscope showing a state of a surface on a copper plate to be roughened a surface thereof according to Example 6, wherein there is shown a primary surface thereof.
FIG. 9B is a photo according to a scanning electron microscope showing a state of a surface on a copper plate to be roughened a surface thereof according to Example 6, wherein there is shown an inner face of a hole thereon.
FIG. 9C is a photo according to a scanning electron microscope showing a state of a surface on a copper plate to be roughened a surface thereof according to Example 6, wherein there is shown an edge part of a hole thereon.
FIG. 10A is a photo according to a scanning electron microscope showing a state of a surface on a copper plate to be roughened a surface thereof according to Example 7, wherein there is shown a primary surface thereof.
FIG. 10B is a photo according to a scanning electron microscope showing a state of a surface on a copper plate to be roughened a surface thereof according to Example 7, wherein there is shown an inner face of a hole thereon.
FIG. 10C is a photo according to a scanning electron microscope showing a state of a surface on a copper plate to be roughened a surface thereof according to Example 7, wherein there is shown an edge part of a hole thereon.
FIG. 11 is a photo according to a scanning electron microscope showing a state of a surface on a copper plate to be roughened a surface thereof according to Comparative example 2.
FIG. 12 is a photo according to a scanning electron microscope showing a state of a surface on a copper plate to be roughened a surface thereof according to Comparative example 4.
FIG. 13 is a photo according to a scanning electron microscope showing a state of a surface on a copper plate to be roughened a surface thereof according to Comparative example 6.
FIG. 14A is a photo according to a scanning electron microscope showing a state of a surface on a copper plate to be roughened a surface thereof according to Comparative example 7, wherein there is shown a primary surface thereof.
FIG. 14B is a photo according to a scanning electron microscope showing a state of a surface on a copper plate to be roughened a surface thereof according to Comparative example 7, wherein there is shown an inner face of a hole thereon.
FIG. 14C is a photo according to a scanning electron microscope showing a state of a surface on a copper plate to be roughened a surface thereof according to Comparative example 7, wherein there is shown an edge part of a hole thereon.
FIG. 15 is a cross sectional view showing one example of a metal core substrate for a circuit board.
FIG. 16 is a photo according to a scanning electron microscope showing a state of a surface on an electrolytic copper foil for a common printed circuit board.

### Description of the reference symbols

- 1: ELECTROLYTIC BATH
- 2: ELECTROPLATING SOLUTION FOR PLATING COPPER
- 3: ELECTRODE
- 3a: POSITIVE ELECTRODE
- 3c: NEGATIVE ELECTRODE
- 4: COPPER PLATE TO BE ROUGHENED A SURFACE THEREOF
- 5: FRAME BODY
- 6: HANGER METAL FITTING
- 7: BUS BAR
- 7a: BUS BAR FOR A POSITIVE ELECTRODE
- 7c: BUS BAR FOR A NEGATIVE ELECTRODE
- 8: INSULATING BAR

## Claims

1. A process for producing a copper plate (4) with a roughened surface, in which protrusions of a fine bump shape are formed on a surface of a copper plate to roughen the surface of the copper plate, wherein the protrusions of a fine bump shape are formed by:
arranging one pair of electrodes (3, 3a, 3c) of the same polarity in opposition to each other in an electroplating solution for plating copper;
arranging the copper plate between the electrodes;
performing at least one cycle of an anodic treatment and a cathodic treatment, one cycle being made up of an anodic treatment in which fine particles of copper are generated on both surfaces of the copper plate, by performing an electrolytic process with the copper plate as a positive electrode and the electrodes as negative electrodes, and a cathodic treatment carried out after the anodic treatment, in which the fine particles of copper are fixed onto the surfaces of the copper plate by performing an electroplating of copper with the copper plate as a negative electrode and the electrodes as positive electrodes, without moving the copper plate with respect to the electrodes.

2. A process for producing a copper plate (4) with a roughened surface, in which protrusions of a fine bump shape are formed on a surface of a copper plate to roughen the surface of the copper plate, wherein the protrusions of a fine bump shape are formed by:
arranging at least two pairs of electrodes (3, 3a, 3c) including one pair of positive electrodes and one pair of negative electrodes, the electrodes of each pair having the same polarity and being arranged in opposition to each other, in the same electroplating solution for plating copper;
arranging the copper plate between the electrodes of one of the pairs of electrodes;
performing at least one cycle of an anodic treatment and a cathodic treatment, the cycle being made up of performing an anodic treatment with the copper plate being stationary arranged between the electrodes of the pair of negative electrodes, with the copper plate serving as a positive electrode, then moving the copper plate to a stationary location between the electrodes of the pair of positive electrodes, and performing a cathodic treatment with the copper plate as a negative electrode.

3. The process for producing a copper plate with a roughened surface as defined in claim 2, comprising:
arranging, in alternation, one pair or a plurality of pairs of positive electrodes in opposition to each other and one pair or a plurality of pairs of negative electrodes in opposition to each other in an electroplating solution for plating copper, the electrode pairs extending on two parallel lines;
successively moving the copper plate from a location between the electrodes at one end to a location between the electrodes at the other end, and alternately performing the anodic treatment and the cathodic treatment.

4. A process for producing a copper plate with a roughened surface, comprising:
performing the process defined in any one of claims 1 to 3 on a combined copper plate, in which two copper plates are overlapped to form one sheet; and
obtaining two copper plates, each having a roughened surface on one side, by separating the combined copper plate into individual copper plates.

5. The process for producing a copper plate with a roughened surface as defined in any one of claims 1 to 4, wherein the anodic treatment is performed with an electric current density of between 1 A/dm² and 8 A/dm² for between three minutes and ten minutes, and the cathodic treatment is performed with an electric current density of between 1 A/dm² and 8 A/dm² for between three minutes and ten minutes.

6. The process for producing a copper plate with a roughened surface as defined in claim 5, wherein the electroplating solution for plating copper is maintained at a temperature of 18°C to 32°C.

7. The process for producing a copper plate with a roughened surface as defined in any one of claims 1 to 6, comprising:
forming, in advance, a predetermined hole at a predetermined position on a copper plate, before performing the anodic treatment or the cathodic treatment.

8. The process for producing a copper plate with a roughened surface as defined in any of claims 1 to 7, wherein a copper plating process is performed with the copper plate as the negative electrode and the electrodes as the positive electrodes in an electroplating solution for plating copper before performing the anodic treatment for the first time.

9. An equipment for producing a copper plate (4) with a roughened surface, comprising:
an electrolytic bath (1) for accommodating an electroplating solution for plating copper;
one pair or a plurality of pairs of positive electrodes (3a) arranged in opposition to each other in the electrolytic bath, the positive electrode pairs extending on two parallel lines;
one pair or a plurality of pairs of negative electrodes (3c) arranged in opposition each other in the electrolytic bath, the negative electrode pairs extending on two parallel lines;
a negative electrode bus bar (7c) that is arranged horizontally above a location between the pair or pairs of positive electrodes, and that is for hanging the copper plate;
a positive electrode bus bar (7a) that is arranged horizontally above a location between the pair or pairs of negative electrodes, and that is for hanging the copper plate;
an insulating bar (8) coupling the negative electrode bus bar and the positive electrode bus bar;
a frame body (5) for holding the copper plate (4); and
a hanger metal fitting (6) for the frame body (5).

10. The equipment according to claim 9,
wherein the positive and negative electrode pairs are arranged in alternation, and
wherein the insulating bar couples adjacent negative and positive electrode bus bars.

## Patentansprüche

1. Verfahren zur Herstellung einer Kupferplatte (4) mit einer aufgerauten Oberfläche, bei dem Vorsprünge mit einer feinen Buckelform auf einer Oberfläche einer Kupferplatte gebildet werden, um die Oberfläche der Kupferplatte aufzurauen, wobei die Vorsprünge mit einer feinen Buckelform gebildet werden durch:
Anordnen eines Elektrodenpaares (3, 3a, 3c) gleicher Polarität gegenüber voneinander in einer Galvanisierungslösung zur Kupferbeschichtung;
Anordnen der Kupferplatte zwischen den Elektroden;
Durchführen mindestens eines Zyklus einer anodischen Behandlung und einer kathodischen Behandlung, wobei ein Zyklus aus einer anodischen Behandlung, bei der feine Kupferpartikel auf beiden Oberflächen der Kupferplatte erzeugt werden, indem ein elektrolytisches Verfahren mit der Kupferplatte als eine positive Elektrode und den Elektroden als negative Elektroden durchgeführt wird, und aus einer nach der anodischen Behandlung durchgeführten kathodischen Behandlung besteht, bei der die feinen Kupferpartikel auf den Oberflächen der Kupferplatte befestigt werden, indem eine Kupfergalvanisierung mit der Kupferplatte als einer negativen Elektrode und den Elektroden als positive Elektroden durchgeführt wird, ohne die Kupferplatte in Bezug auf die Elektroden zu bewegen.

2. Verfahren zur Herstellung einer Kupferplatte (4) mit einer aufgerauten Oberfläche, bei dem Vorsprünge mit einer feinen Buckelform auf einer Oberfläche einer Kupferplatte gebildet werden, um die Oberfläche der Kupferplatte aufzurauen, wobei die Vorsprünge mit einer feinen Buckelform gebildet werden durch:
Anordnen von mindestens zwei Elektrodenpaaren (3, 3a, 3c), welche ein Paar positive Elektroden und ein Paar negative Elektroden enthalten, in derselben Galvanisierungslösung zur Kupferbeschichtung, wobei die Elektroden jedes Paares die gleiche Polarität aufweisen und gegenüber voneinander angeordnet sind;
Anordnen der Kupferplatte zwischen den Elektroden eines der Elektrodenpaare;
Durchführen mindestens eines Zyklus einer anodischen Behandlung und einer kathodischen Behandlung, wobei der Zyklus aus dem Durchführen einer anodischen Behandlung, wobei die Kupferplatte stationär zwischen den Elektroden des negativen Elektrodenpaares angeordnet ist, und wobei die Kupferplatte als eine positive Elektrode dient, aus dem anschließenden Bewegen der Kupferplatte zu einer stationären Position zwischen den Elektroden des positiven Elektrodenpaares und aus dem Durchführen einer kathodischen Behandlung mit der Kupferplatte als eine negative Elektrode besteht.

3. Verfahren zur Herstellung einer Kupferplatte mit einer aufgerauten Oberfläche nach Anspruch 2, umfassend:
abwechselndes Anordnen eines Paares oder einer Vielzahl von Paaren positiver Elektroden gegenüber voneinander und eines Paares oder einer Vielzahl von Paaren negativer Elektroden gegenüber voneinander in einer Galvanisierungslösung zur Kupferbeschichtung, wobei sich die Elektrodenpaare auf zwei parallelen Linien erstrecken;
sukzessives Bewegen der Kupferplatte von einer Position zwischen den Elektroden an einem Ende zu einer Position zwischen den Elektroden am anderen Ende und abwechselndes Durchführen der anodischen Behandlung und der kathodischen Behandlung.

4. Verfahren zur Herstellung einer Kupferplatte mit einer aufgerauten Oberfläche, umfassend:
Durchführen des in einem der Ansprüche 1 bis 3 definierten Verfahrens an einer kombinierten Kupferplatte, bei der zwei Kupferplatten übereinandergelegt werden, um ein Blatt zu bilden; und
Erhalten von zwei Kupferplatten, die jeweils auf einer Seite eine aufgeraute Oberfläche aufweisen, durch Trennen der kombinierten Kupferplatte in einzelne Kupferplatten.

5. Verfahren zur Herstellung einer Kupferplatte mit einer aufgerauten Oberfläche nach einem der Ansprüche 1 bis 4, wobei die anodische Behandlung mit einer elektrischen Stromdichte zwischen 1 A/dm² und 8 A/dm² zwischen drei und zehn Minuten lang durchgeführt wird und die kathodische Behandlung mit einer elektrischen Stromdichte zwischen 1 A/dm² und 8 A/dm² zwischen drei und zehn Minuten lang durchgeführt wird.

6. Verfahren zur Herstellung einer Kupferplatte mit einer aufgerauten Oberfläche nach Anspruch 5, wobei die Galvanisierungslösung zur Kupferbeschichtung bei einer Temperatur von 18°C bis 32°C gehalten wird.

7. Verfahren zur Herstellung einer Kupferplatte mit einer aufgerauten Oberfläche nach einem der Ansprüche 1 bis 6, umfassend:
Bilden, im Voraus, eines vorbestimmten Lochs an einer vorbestimmten Position auf einer Kupferplatte, bevor die anodische Behandlung oder die kathodische Behandlung durchgeführt wird.

8. Verfahren zur Herstellung einer Kupferplatte mit einer aufgerauten Oberfläche nach einem der Ansprüche 1 bis 7, wobei ein Kupferbeschichtungsverfahren mit der Kupferplatte als die negative Elektrode und den Elektroden als die positiven Elektroden in einer Galvanisierungslösung zur Kupferbeschichtung durchgeführt wird, bevor die anodische Behandlung zum ersten Mal durchgeführt wird.

9. Vorrichtung zum Herstellen einer Kupferplatte (4) mit einer aufgerauten Oberfläche, umfassend:
ein elektrolytisches Bad (1) zur Aufnahme einer Galvanisierungslösung zur Kupferbeschichtung;
ein Paar oder eine Vielzahl von Paaren von positiven Elektroden (3a), die im elektrolytischen Bad gegenüber voneinander angeordnet sind, wobei sich die positiven Elektrodenpaare auf zwei parallelen Linien erstrecken;
ein Paar oder eine Vielzahl von Paaren von negativen Elektroden (3c), die im elektrolytischen Bad gegenüber voneinander angeordnet sind, wobei sich die negativen Elektrodenpaare auf zwei parallelen Linien erstrecken;
eine negative Elektrodensammelschiene (7c), die horizontal über einer Stelle zwischen dem Paar oder den Paaren von positiven Elektroden angeordnet ist und die zum Aufhängen der Kupferplatte dient;
eine positive Elektrodensammelschiene (7a), die horizontal über einer Stelle zwischen dem Paar oder den Paaren von negativen Elektroden angeordnet ist und die zum Aufhängen der Kupferplatte dient;
eine Isolierschiene (8), die die negative Elektrodenschiene und die positive Elektrodenschiene koppelt;
einen Rahmenkörper (5) zum Halten der Kupferplatte (4); und
eine Metallbeschlagaufhängung (6) für den Rahmenkörper (5).

10. Vorrichtung nach Anspruch 9,
wobei die positiven und negativen Elektrodenpaare abwechselnd angeordnet sind, und
wobei die Isolierschiene benachbarte negative und positive Elektrodensammelschienen koppelt.

## Revendications

1. Procédé de fabrication d'une plaque de cuivre (4) avec une surface rendue rugueuse, dans lequel des saillies en forme de bosse fine sont formées sur une surface d'une plaque de cuivre pour rendre rugueuse la surface de la plaque de cuivre, dans lequel les saillies d'une forme de bosse fine sont formées par :
la disposition d'une paire d'électrodes (3, 3a, 3c) de même polarité en opposition l'une par rapport à l'autre dans une solution d'électrodéposition pour dépôt de cuivre ;
la disposition de la plaque de cuivre entre les électrodes ;
la réalisation d'au moins un cycle d'un traitement anodique et d'un traitement cathodique, un cycle étant constitué d'un traitement anodique dans lequel de fines particules de cuivre sont générées sur les deux surfaces de la plaque de cuivre en effectuant un processus électrolytique avec la plaque de cuivre servant d'électrode positive et les électrodes servant d'électrodes négatives, et d'un traitement cathodique effectué après le traitement anodique, dans lequel les fines particules de cuivre sont fixées sur les surfaces de la plaque de cuivre en effectuant une électrodéposition de cuivre avec la plaque de cuivre servant d'électrode négative et les électrodes servant d'électrodes positives, sans bouger la plaque de cuivre par rapport aux électrodes.

2. Procédé de fabrication d'une plaque de cuivre (4) avec une surface rendue rugueuse, dans lequel des saillies en forme de bosse fine sont formées sur une surface d'une plaque de cuivre pour rendre rugueuse la surface de la plaque de cuivre, dans lequel les saillies d'une forme de bosse fine sont formées par :
la disposition d'au moins deux paires d'électrodes (3, 3a, 3c) incluant une paire d'électrodes positives et une paire d'électrodes négatives, les électrodes de chaque paire ayant la même polarité et étant disposées en opposition l'une par rapport à l'autre dans la même solution de dépôt électrolytique de cuivre ;
la disposition de la plaque de cuivre entre les électrodes d'une des paires d'électrodes ;
la réalisation d'au moins un cycle d'un traitement anodique et d'un traitement cathodique, le cycle étant constitué par la réalisation d'un traitement anodique avec la plaque de cuivre étant stationnairement disposée entre les électrodes de la paire d'électrodes négatives, la plaque de cuivre servant d'électrode positive, puis par le déplacement de la plaque de cuivre vers un emplacement stationnaire entre les électrodes de la paire d'électrodes positives et par la réalisation d'un traitement cathodique avec la plaque de cuivre servant d'électrode négative.

3. Procédé de fabrication d'une plaque de cuivre avec une surface rendue rugueuse selon la revendication 2, comprenant :
la disposition, en alternance, d'une paire ou d'une pluralité de paires d'électrodes positives en opposition l'une par rapport à l'autre et d'une paire ou d'une pluralité de paires d'électrodes négatives en opposition l'une par rapport à l'autre dans une solution d'électrodéposition pour dépôt de cuivre, les paires d'électrodes s'étendant le long de deux lignes parallèles ;
le déplacement successif de la plaque de cuivre d'un emplacement entre les électrodes à une extrémité à un emplacement entre les électrodes à l'autre extrémité, et l'exécution en alternance du traitement anodique et du traitement cathodique.

4. Procédé de fabrication d'une plaque de cuivre avec une surface rendue rugueuse, comprenant :
l'exécution du procédé défini dans l'une quelconque des revendications 1 à 3 sur une plaque de cuivre combinée, dans laquelle deux plaques de cuivre sont superposées pour former une feuille ; et
l'obtention de deux plaques de cuivre, chacune ayant une surface rendue rugueuse d'un côté, en séparant la plaque de cuivre combinée en plaques de cuivre individuelles.

5. Procédé de fabrication d'une plaque de cuivre ayant une surface rendue rugueuse selon l'une quelconque des revendications 1 à 4, dans lequel le traitement anodique est effectué avec une densité de courant électrique comprise entre 1 A/dm² et 8 A/dm² pendant trois à dix minutes, et le traitement cathodique est effectué avec une densité de courant électrique comprise entre 1 A/dm² et 8 A/dm² pendant trois à dix minutes.

6. Procédé de fabrication d'une plaque de cuivre avec une surface rendue rugueuse selon la revendication 5, dans lequel la solution d'électrodéposition pour dépôt de cuivre est maintenue à une température entre 18°C à 32°C.

7. Procédé de fabrication d'une plaque de cuivre ayant une surface rendue rugueuse selon l'une quelconque des revendications 1 à 6, comprenant :
la formation, au préalable, d'un trou prédéterminé à une position prédéterminée sur une plaque de cuivre, avant d'effectuer le traitement anodique ou le traitement cathodique.

8. Procédé de fabrication d'une plaque de cuivre ayant une surface rendue rugueuse telle que définie dans l'une quelconque des revendications 1 à 7, dans lequel un procédé de dépôt de cuivre est effectué avec la plaque de cuivre servant d'électrode négative et les électrodes servant d'électrodes positives dans une solution d'électrodéposition pour dépôt de cuivre avant de réaliser pour la première fois le traitement anodique.

9. Dispositif pour produire une plaque de cuivre (4) avec une surface rendue rugueuse, comprenant :
un bain électrolytique (1) pour recevoir une solution d'électrodéposition pour dépôt de cuivre ;
une paire ou une pluralité de paires d'électrodes positives (3a) disposées en opposition les unes par rapport aux autres dans le bain électrolytique, les paires d'électrodes positives s'étendant le long de deux lignes parallèles ;
une paire ou une pluralité de paires d'électrodes négatives (3c) disposées en opposition les unes par rapport aux autres dans le bain électrolytique, les paires d'électrodes négatives s'étendant le long de deux lignes parallèles ;
une barre bus d'électrode négative (7c) qui est disposée horizontalement au-dessus d'un emplacement entre la paire ou les paires d'électrodes positives, et qui est destinée à suspendre la plaque de cuivre ;
une barre bus d'électrode positive (7a) qui est disposée horizontalement au-dessus d'un emplacement entre la paire ou les paires d'électrodes négatives, et qui est destinée à suspendre la plaque de cuivre ;
une barre isolante (8) couplant la barre bus d'électrode négative et la barre bus d'électrode positive ;
un corps de cadre (5) pour maintenir la plaque de cuivre (4) ; et
un raccord de suspension métallique (6) pour le corps de cadre (5).

10. Dispositif selon la revendication 9,
dans lequel les paires d'électrodes positives et négatives sont disposées en alternance, et
dans lequel la barre isolante couple des barres de bus d'électrodes négatives et positives adjacentes.
